(19) Europäisches Patentamt
European Patent Office
Office européen des brevets

(11) **EP 4 607 585 B1**

(12) **EUROPEAN PATENT SPECIFICATION**

(45) Date of publication and mention
of the grant of the patent:
**10.06.2026 Bulletin 2026/24**

(51) International Patent Classification (IPC):
***H10W 40/47*** *(2026.01)*    ***H10W 40/22*** *(2026.01)*
***H10W 40/00*** *(2026.01)*    ***H10W 70/02*** *(2026.01)*

(21) Application number: **24305303.0**

(52) Cooperative Patent Classification (CPC):
**H10W 40/47; H10W 40/228; H10W 70/02;**
H10W 40/037

(22) Date of filing: **23.02.2024**

(54) **COOLING BLOCK FOR COOLING A HEAT-GENERATING ELECTRONIC COMPONENT**

KÜHLBLOCK ZUR KÜHLUNG EINES WÄRMEERZEUGENDEN ELEKTRONISCHEN BAUTEILS

BLOC DE REFROIDISSEMENT POUR REFROIDIR UN COMPOSANT ÉLECTRONIQUE
GÉNÉRANT DE LA CHALEUR

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**27.08.2025 Bulletin 2025/35**

(73) Proprietor: **OVH
59100 Roubaix (FR)**

(72) Inventors:
• **BAUDUIN, Hadrien
59650 Villeneuve d'Ascq (FR)**
• **CHEHADE, Ali
59283 Moncheaux (FR)**

(74) Representative: **BCF Global
17-21, rue Saint-Fiacre
75002 Paris (FR)**

(56) References cited:
**WO-A1-2023/235065**    **DE-A1- 102011 118 483
US-A1- 2009 145 581**

**Description**

FIELD OF TECHNOLOGY

The present technology relates to cooling blocks for cooling heat-generating electronic components.

BACKGROUND

Heat dissipation is an important consideration for computer systems. Notably, many components of a computer system, such as a processor (also referred to as central processing unit (CPU)), generate heat and thus require cooling to avoid performance degradation and, in some cases, failure. Similar considerations arise for systems other than computer systems (e.g., power management systems). Thus, in many cases, different types of cooling solutions are implemented to promote heat dissipation from heat-generating electronic components, with the objective being to collect and conduct thermal energy away from these heat-generating electronic components. For instance, in a data center, in which multiple electronic systems (e.g., servers, networking equipment, power equipment) are continuously operating and generating heat, such cooling solutions may be particularly important.

One example of a cooling solution is a heat sink which relies on a heat transfer medium (e.g., a gas or liquid) to carry away the heat generated by a heat-generating electronic component. For instance, a cooling block (sometimes referred to as a "water block" or "cold plate") can be thermally coupled to a heat-generating electronic component and water (or other fluid) is made to flow through a conduit in the cooling block to absorb heat from the heat-generating electronic component. As water flows out of the cooling block, so does the thermal energy collected thereby. Patent Document DE 10 2011 118483 A1 discloses an example of such a cooling block with pins inside the conduit. However, in many cases, efficient cooling blocks may be difficult and/or expensive to manufacture.

There is therefore a desire for a cooling block which can alleviate at least some of these drawbacks.

SUMMARY

It is an object of the present technology to ameliorate at least some of the inconveniences present in the prior art.

Broadly, embodiments of the present technology are based on an understanding by the Developers that cooling blocks with improved thermohydraulic efficiency as well as improved methods of their manufacture are needed to deal with increasing cooling demands of heat-generating electronic components.

Some conventional cooling blocks have micro-channels formed therein for cooling fluid to flow. However, cooling blocks with micro-channels are susceptible to blocking due to impurities in the cooling fluid as well as fouling. They are also not easy to manufacture.

Therefore, Developers have developed a cooling block and its method of manufacture which avoids micro-channels. In certain embodiments, cooling blocks with a fluid conduit having a diameter of more than 1.0 mm are provided. The cooling blocks of the present technology include pins in the fluid conduit which can help with the hydrodynamic properties of the cooling fluid flow. In certain embodiments, the pins have an airfoil-like shape having head and tail ends and are symmetric about a longitudinal axis but asymmetric about a lateral axis of the pin. The head and tail ends may be pointed. A shape of the walls defining the fluid conduit track the shape of the pin facing the wall. This can provide a hydrodynamic improvement over conventional pins in cooling blocks. For example, flow separation during cooling fluid flow may be avoided.

Developers have also devised a method of manufacture in which the fluid conduit and the pins can be manufactured using a milling cutter and in which a path of the milling cutter corresponds to a shape of the fluid conduit. The shape of the fluid conduit and thus the path of the milling cutter can be defined as trigonometric (sinusoidal or cosine) wave with an asymmetry about a lateral axis. Sharp turns can thus be avoided in the path of the milling cutter in some embodiments leading to ease of manufacture.

According to one aspect of the present technology, there is provided a cooling block for cooling a heat-generating electronic component, the cooling block comprising a body having defined therein a fluid conduit for circulating a cooling fluid therethrough, the fluid conduit being defined by at least one passage extending between an inlet point and an outlet point, the at least one passage comprising: a longitudinal passage axis; first and second internal sidewalls defining the at least one passage; a plurality of pins disposed between the internal sidewalls for deflecting the cooling fluid flowing within the at least one passage, each pin having a head end and a tail end, and the plurality of pins being disposed as a pin row in the at least one passage with the head end and the tail end of each pin disposed along the longitudinal passage axis, wherein at least a portion of a perimeter shape of each pin is defined by a nested trigonometric function including a factor of asymmetry, the nested trigonometric function including a factor of asymmetry defining a spline which is used to manufacture the pin.

In some embodiments, the nested trigonometric function comprises a sinusoidal function.

In some embodiments, the perimeter shape of each pin is symmetric about the longitudinal passage axis, and is asymmetric about a lateral axis extending through the pin. The lateral axis extends through a center length of the pin in some embodiments.

In some embodiments, the perimeter shape of each pin has a first side and a second side, the first and second sides being disposed on either side of the longitudinal passage axis, each of the first side and the second side being defined by half a wavelength of the nested trigonometric function including the factor of asymmetry.

In some embodiments, a profile of at least a portion of the first and/or second internal sidewall follows a profile of the first and/or second side of the pin.

In some embodiments, the longitudinal passage axis is a central linear axis of the at least one passage.

In some embodiments, each pin is oriented such that the tail end is downstream from the head end.

In some embodiments, the at least one passage has a plurality of expanded portions and a plurality of constricted portions distributed alternatingly with the expanded portions in the longitudinal direction; the expanded portions have a first width measured in the lateral direction; the constricted portions have a second width in the lateral direction; the first width is greater than the second width; and the pins are disposed in the expanded portions.

In some embodiments, each of the first and second internal sidewalls has a plurality of rounded sections forming the expanded portions of the passage, and each rounded section is aligned, longitudinally, with a corresponding pin.

In some embodiments, a spacing between the rounded section and a portion of the pin facing the rounded section is constant.

In some embodiments, the first and second internal sidewalls are symmetric to each other about the longitudinal passage axis.

In some embodiments, the first and second internal sidewalls are scalloped.

In some embodiments, one of the first and second internal sidewalls and the pin row define a channel along the at least one passage, the channel having a constant width.

In some embodiments, the at least one passage comprising the plurality of pins comprises at least: a first passage comprising a first plurality of pins, and a second passage, adjacent to the first passage and laterally offset therefrom, comprising a second plurality of pins; wherein the first plurality of pins is off-set from the second plurality of pins, along a longitudinal direction of the cooling block.

In some embodiments, the perimeter shape of the pins of the first plurality of pins is a mirror image along a lateral axis of the perimeter shape of the pins of the second plurality of pins.

In some embodiments, the fluid conduit comprises an inlet manifold portion and an outlet manifold portion, the first passage and the second passage extending between the inlet and manifold portions.

In some embodiments, the longitudinal passage axis of the at least one passage comprises: a first longitudinal axis extending in a longitudinal direction, and a second longitudinal axis extending in the longitudinal direction and parallel to the first longitudinal axis; and the plurality of pins comprises: a first set of pins having a first pin head end and a first pin tail end, the pins of the first set of pins being disposed in the at least one passage such that the first linear axis traverses the head end and the tail end of each pin of the first set of pins; and a second set of pins having a second pin head end and a second pin tail end, the pins of the second set of pins being disposed in the at least one passage such that the second linear axis traverses the head end and the tail end of each pin of the second set of pins.

In some embodiments, each pin of the first set of pins is symmetric about the first longitudinal axis, and each pin of the second set of pins is symmetric about the second longitudinal axis, and wherein each pin of the first and second sets of pins is asymmetric about a respective lateral axis extending through a centre of the respective pins.

In some embodiments, each pin of the first set of pins is oriented such that the first pin tail end is downstream from the first pin head end, and each pin of the second set of pins are oriented such that the second pin head end is downstream from the second pin tail end. In other words, adjacent pins of the first and second set of pins have a head end to tail end configuration or have a different longitudinal orientation.

In some embodiments, the first pin tail end of the first pin is disposed longitudinally between a longitudinal position of the second pin tail end and the second pin head end.

From another aspect, there is provided a method for manufacturing a cooling block configured to cool a heat-generating electronic component, the method comprising: providing a base for forming part of the cooling block; forming at least one passage of a fluid conduit of the cooling block by: milling a first channel in a surface of the base following a first path defined by a first trigonometric spline, the first trigonometric spline defined by a nested trigonometric function including a factor of asymmetry; milling a second channel in the surface of the base following a second path defined by a second trigonometric spline, the second trigonometric spline defined by the nested trigonometric function including the factor of asymmetry, the first and second trigonometric splines extending in a longitudinal direction of the cooling block and being arranged such that the first channel and the second channel are interconnected to each other such that, in use, cooling fluid flowing within the passage flows within the first channel and the second channel; said milling of the first and second channels forming the at least one passage having a plurality of pins spaced from each other as a pin row along the longitudinal direction.

In some embodiments, the at least one passage has a linear axis extending in the longitudinal direction, wherein the first trigonometric spline and the second trigonometric spline are symmetric about the linear axis.

In some embodiments, the first trigonometric spline extends from a first end to a second end; the second trigonometric spline extends from a first end to a second end; and the first or second end of the first trigonometric spline and the first or second end of the second trigonometric spline are coincident or laterally off-set.

Embodiments of the present technology each have at least one of the above-mentioned object and/or aspects, but do not necessarily have all of them.

Additional and/or alternative features, aspects and advantages of embodiments of the present technology will become apparent from the following description, the accompanying drawings and the appended claims.

It is to be understood that terms relating to the position and/or orientation of components such as "upper", "lower", "top", "bottom", "front", "rear", "left", "right", "longitudinal", "lateral", "vertical", etc. are used herein to simplify the description and are not intended to be limitative of the particular position/orientation of the components in use.

BRIEF DESCRIPTION OF THE DRAWINGS

For a better understanding of the present technology, as well as other aspects and further features thereof, reference is made to the following description which is to be used in conjunction with the accompanying drawings, where:

Fig. 1 is a perspective view, taken from a top, front side of a cooling block according to an embodiment of the present technology;

Fig. 2 is a cross-sectional view of the cooling block of Fig. 1 taken along line A-A in Fig. 1, and showing a heat-generating electronic component cooled thereby;

Fig. 3 is a top plan view of a base of the cooling block of Fig. 1;

Fig. 4 is a detailed view of part of Fig. 3 showing multiple passages and pins of a fluid conduit of the cooling block;

Fig. 5 is a schematic illustration of an embedded sinusoidal function with an asymmetry parameter for defining a perimeter shape of the pins and sidewalls of the multiple passages of Fig. 4, according to embodiments of the present technology;

Fig. 6 is a top plan view of the base of the cooling block of Fig. 3 after having formed a first channel of a first one of the passages of the cooling block, according to embodiments of the present technology;

Fig.7 is a top plan view of the base of the cooling block of Fig. 3 after having formed a second channel of the first one of the passages of the cooling block, according to embodiments of the present technology;

Fig. 8 is a top plan view of the base of the cooling block of Fig. 3 after having formed a second one of the passages of the cooling block, according to embodiments of the present technology;

Fig. 9 is a top plan view of the base of the cooling block of Fig. 1, according to an alternative embodiment;

Fig. 10 is a top plan view of the base of the cooling block of Fig. 1, according to another alternative embodiment;

Fig. 11 is a top plan view of the base of the cooling block of Fig. 1, according to an alternative embodiment in which each passage is defined by two pin rows;

Fig. 12 is a detailed view of section B in Fig. 11;

Figs. 13 to 15 are top plan views of the base of Fig. 11 in progressive stages of manufacturing thereof, according to embodiments of the present technology;

Fig. 16A and 16B are top plan views of part of the base of the cooling block of Fig. 1 according to alternative embodiments in which each passage of the cooling block is defined in part by three pin rows;

Fig. 17 is a top plan view of the base of the cooling block according to an alternative embodiment in which the cooling block has a single passage defined in part by sixteen pin rows; and

Fig. 18 is flow diagram depicting a method for making the cooling block of Fig. 1, according to embodiments of the present technology.

DETAILED DESCRIPTION

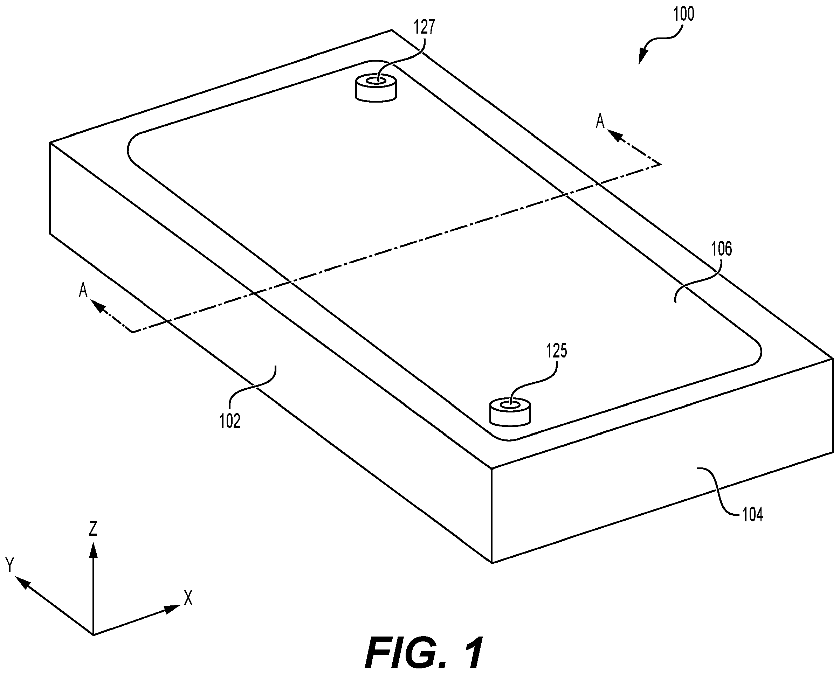

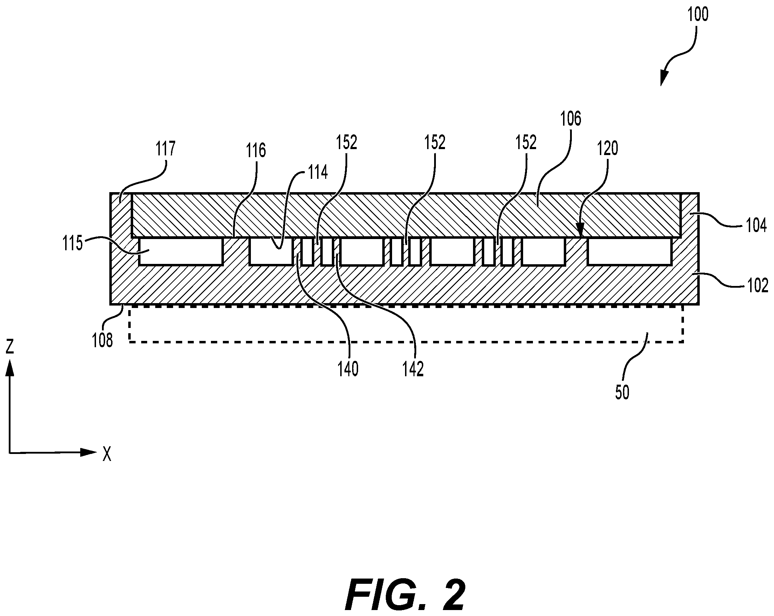

Figs. 1 and 2 illustrate a cooling block 100 in accordance with an embodiment of the present technology. The cooling block 100 is configured for cooling a heat-generating electronic component 50 (illustrated schematically in Fig. 2). In this example, the heat-generating electronic component 50 is a central processing unit (CPU). For instance, the heat-generating electronic component 50 may be part of a server operating within a data center. In use, the heat-generating electronic component 50 generates a significant amount of heat and can therefore benefit from cooling. It is contemplated that the heat-generating electronic component 50 could be any other suitable heat-generating electronic component (e.g., a graphics processing unit (GPU), a semiconductor, a memory unit, etc.).

As will be described in detail below, the cooling block 100 is configured, via the design of a fluid conduit 115 thereof, to promote turbulent flow of cooling fluid within the fluid conduit 115. Increased turbulent flow within the fluid conduit 115 can optimize the heat absorption capability of the cooling block 100, therefore resulting in the cooling block 100 more efficiently absorbing heat from the heat-generating electronic component 50.

The cooling block 100 will now be described with reference to Figs. 1 to 3. The cooling block 100 has a body 102 including a base 104 and a cover 106 which are connected to each other. For instance, in this example, the cover 106 is welded to the base 104 (e.g., via laser welding). The cover 106 may be fixed to the base 104 differently in other embodiments. As shown in Fig. 2, the base 104 includes a thermal transfer surface 108 disposed on a lower side of the base 104. The thermal transfer surface 108 is configured to be placed in thermal contact with the heat-generating electronic component 50. It is to be understood that the thermal transfer surface 108 can be in thermal contact with the heat-generating electronic component 50 whether the thermal transfer surface is in direct contact with the heat-generating electronic component 50 or a thermal interface material (e.g., a thermal paste, a thermal pad, a graphite sheet, etc.) is disposed therebetween with the express intention of improving the heat transfer between the heat-generating electronic component 50 and the cooling block 100.

As shown in Fig. 2, together, the base 104 and the cover 106 define the internal fluid conduit 115 within which a cooling fluid is circulated to absorb heat from the heat-generating electronic component 50. The internal fluid conduit 115 extends from an inlet 110 to an outlet 112. In this example, the inlet 110 and the outlet 112 are disposed near opposite corners of the cooling block 100. The inlet 110 and the outlet 112 could be disposed at different locations in other embodiments. Furthermore, in this embodiment, the cooling fluid circulated through the internal fluid conduit 115 is demineralized water. However, the cooling fluid may be any other suitable cooling fluid (e.g., a refrigerant) in other embodiments. In some embodiments, the cooling fluid may be capable of two-phase flow such that the cooling fluid can change phases from liquid to gas and vice-versa based on a temperature thereof. The cooling fluid circulating within the cooling block 100 will thus, at some point, be in the liquid phase, however the cooling fluid may not necessarily be in liquid phase throughout (e.g., the cooling fluid may evaporate from liquid to gas when its temperature reaches a certain value).

In this embodiment, the cover 106 is received in a pocket 120 (Fig. 2) defined by the base 104 such that a lower surface 114 of the cover 106 is in contact with an upper surface 116 of the base 104. The upper surface 116 and a rim portion 117 of the base 104 define the pocket 120 of the base 104 in which the cover 106 is received. The upper surface 116 is disposed on an upper side of the base 104 (i.e., on an opposite side from the thermal transfer surface 108) and therefore is offset from the thermal transfer surface 108 in a height direction (i.e., along the Z-axis) of the cooling block 100 that is normal to the thermal transfer surface 108. In other embodiments, the base 104 may not define a pocket 120 to receive the cover 106 (e.g., the cover 106 may be welded to the base 104 along a periphery thereof). In such embodiments, the upper surface 116 of the base 104 is not surrounded by the rim portion 117.

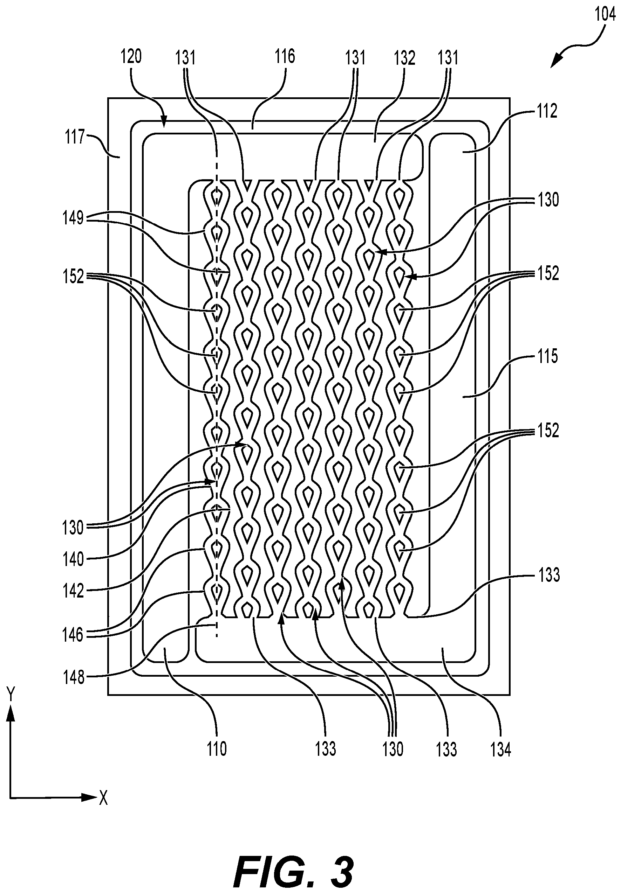

With reference to Figs. 2 and 3, in this embodiment, a path of the fluid conduit 115 is defined by the base 104 which is manufactured to have at least one passage 130 that is designed such as to promote turbulent flow as the cooling fluid flows within the passage 130. The manner in which the base 104 is designed and manufactured will be described in greater detail further below.

In this embodiment, the cover 106 is a plate member that is generally planar and shaped to be received within the pocket 120. Notably, the lower surface 114 of the cover 106 is a flat surface that closes off the fluid conduit 115 from its upper side. It is contemplated that, in other embodiments, the cover 106 could define the path of the fluid conduit 115 in part or in its entirety (e.g., the passages 130 could instead be defined by the cover 106). As shown in Fig. 1, in this embodiment, an inlet connection 125 and an outlet connection 127 are provided on the cover 106 and are in fluid communication with the inlet 110 and the outlet 112 of the fluid conduit 115, respectively. The inlet and outlet connections 125, 127 are connected to piping (not shown) to route cooling fluid to the cooling block 100 and discharge cooling fluid from the cooling block 100 respectively. The piping may fluidly connect the cooling block 100 with a fluid source, for example.

The fluid conduit 115 will now be described in greater detail with reference to Fig. 3. In this embodiment, there are provided a plurality of passages 130. The fluid conduit 115 has an inlet manifold portion 132 that is fluidly communicable with the inlet 110 and an outlet manifold portion 134 that that is fluidly communicable with the outlet 112. The passages 130 extend between the inlet and outlet manifold portions 132, 134 thereby fluidly connecting the inlet manifold portion 132 to the outlet manifold portion 134. As can be seen, in this embodiment, the passages 130 are parallel to each other and extend in a longitudinal direction (i.e., along the Y-axis) of the cooling block 100. In addition, the passages 130 are in a parallel flow configuration whereby cooling fluid flows through the passages 130 in parallel rather than in series. In other words, as cooling fluid flows from the inlet 110 to the outlet 112 of the fluid conduit 115, the cooling fluid flow is split between the passages 130.

It is contemplated that, in other embodiments, the inlet and outlet manifold portions 132, 134 may be omitted. For instance, as will be seen further below, in some embodiments, multiple passages 130 may be fluidly connected to each other in series rather than in parallel. In yet other embodiments, there may be provided a single passage 130 configured to provide a tortuous fluid path.

The particular configuration of each passage 130 of the embodiment of Fig. 3 will now be described. In this embodiment, all of the passages 130 have generally the same configuration and therefore only one of the passages 130 will be described in detail herein. It is to be understood that the same description applies to the other passages 130 unless mentioned otherwise. As can be seen in Fig. 3, the passage 130 extends between an inlet point 131 and an outlet point 133 along the longitudinal direction of the cooling block 100. The outlet point 133 is downstream from the inlet point 131. In this embodiment, the inlet and outlet points 131, 133 are located at the inlet and outlet manifold portions 132, 134 respectively.

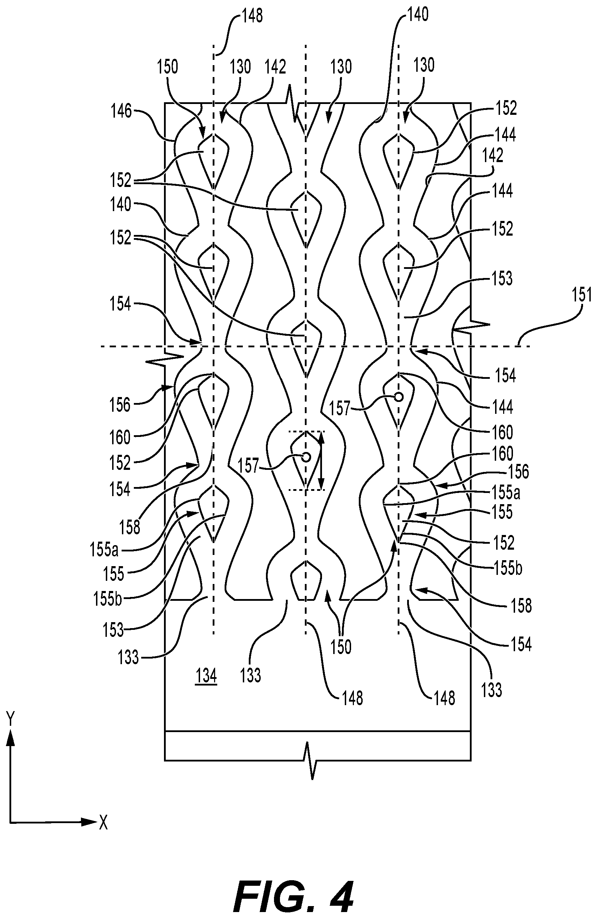

With particular reference to Fig. 4, the passage 130 is defined between internal sidewalls 140, 142 extending between the inlet and outlet points 131, 133 and facing each other such that, as cooling fluid flows within the passage 130, the cooling fluid is bound between the internal sidewalls 140, 142. The internal sidewalls 140, 142 are oppositely face each other and extend generally along the Y-axis and have a height extending generally along the Z-axis.

In this embodiment, each of the internal sidewalls 140, 142 has a scalloped shape and thus comprises a plurality of rounded sections 144 distributed along the longitudinal direction of the cooling block 100. In this example, the rounded sections 144 are regularly repeated along the longitudinal direction of the cooling block. The rounded sections 144 have a same profile as each other. Each rounded section 144 has a concave side 146 thereof facing inwardly toward a longitudinal passage axis 148, which in this embodiment is a central linear axis, that extends along the longitudinal direction of the cooling block 100. In this embodiment, the longitudinal passage axis 148 bisects the passage 130 laterally of the cooling block 100 (i.e., along the X-axis). The lateral direction may thus also be referred to as a "passage width direction".

It will be noted that each rounded section 144 comprising the concave configuration has a curve peak 149. The rounded sections 144 of the internal sidewall 140 are aligned with the rounded sections 144 of the internal sidewall 142 in the longitudinal direction such that respective curve peaks 149 of the rounded sections 144 of the internal sidewalls 140, 142 are longitudinally aligned with each other (i.e. at a same position on the Y-axis). The curve peak 149 represents the furthest point of the internal side walls 140, 142 from the longitudinal passage axis 148. The internal side walls 140, 142 are mirror images of each other about the longitudinal passage axis 148 (i.e. the internal side walls 140, 142 are symmetric about the longitudinal passage axis 148).

Looking at a given rounded section 144, it can be seen that the profile of the given rounded section is asymmetrical along the longitudinal direction (Y-axis). This is best seen in Fig. 4 which shows a lateral axis 151 extending centrally of a length of the given rounded section 144. The curve peak 149 is off-centre along a length of the rounded section 144 along the Y-axis. In certain embodiments, the shape of the rounded section 144 of each of the internal sidewalls 140, 142 is defined by a nested trigonometric function including a factor of asymmetry, which will be described in further detail below.

There is further provided, in each passage 130, a plurality of pins 152. Each pin 152 extends from a floor 153 of the passage 130 along the Z-axis and has a perimeter shape 155. The perimeter shape 155 is a cross-sectional profile of the pin 152 through a plane transverse to the Z-axis (parallel to the thermal transfer surface 108). The pins 152 are arranged as pin rows 150. In the embodiment of Fig. 3, there is provided a single pin row 150 in each passage 130. In other embodiments, which will be described later, each passage 130 comprises more than one pin row 150.

In use, the pins 152 of each pin row 150 deflect the cooling fluid flowing within the fluid conduit 115 toward either side of the longitudinal passage axis 148. As can be seen, the pin row 150 is disposed between the opposite internal sidewalls 140, 142. The pins 152 of the pin row 150 are spaced apart along the longitudinal direction and aligned with each other such that the longitudinal passage axis 148 of each passage 130 traverses each pin 152. As can be seen, this arrangement of the pin row 150 imparts the passage 130 with a catenulate (i.e., chain-like) shape. More specifically, in this embodiment, the passage 130 has a plurality of constricted portions 154 and a plurality of expanded portions 156 disposed alternately along the longitudinal direction and which impart, together with the pins 152, the catenulate shape to the passage 130. The expanded portions 156 of the passage 130 are defined by the oppositely facing rounded sections 144 of the internal sidewalls 140, 142. The constricted and expanded portions 154, 156 are referenced as such due to their relative dimensions. Notably, the expanded portions 156 of the passage 130 have a width that is greater than a width of the constricted portions 154. The widths of the constricted and expanded portions 154, 156 are measured along the lateral direction. In this embodiment, the pins 152 are disposed along the expanded portions 156 (i.e., the pins 152 of the pin row 150 are contained within respective ones of the expanded portions 156).

Returning to Fig. 4, in this embodiment, each pin 152 of the pin row 150 defining the passage 130 has a lanceolate profile along a plane parallel to the thermal transfer surface 108 and traversing the pins 152 (transverse to the Z-axis). Each pin 152 has a tail end 158 and a head end 160. The tail and head ends 158, 160 are opposite each other along the longitudinal direction. The tail end 158 is downstream from the head end 160. The tail and head ends 158, 160 are aligned in the lateral direction and the longitudinal passage axis 148 of the passage 130 extends through both the tail and head ends 158, 160. In this example, the pins 152 are symmetric about the longitudinal passage axis 148.

In certain embodiments (not shown), the pins 152 of each adjacent passage 130 are oriented 180 degrees to the pins 152 of the adjacent passage. In other words, the pins 152 on adjacent passage 130 have a head-to-toe orientation or have a different longitudinal orientation.

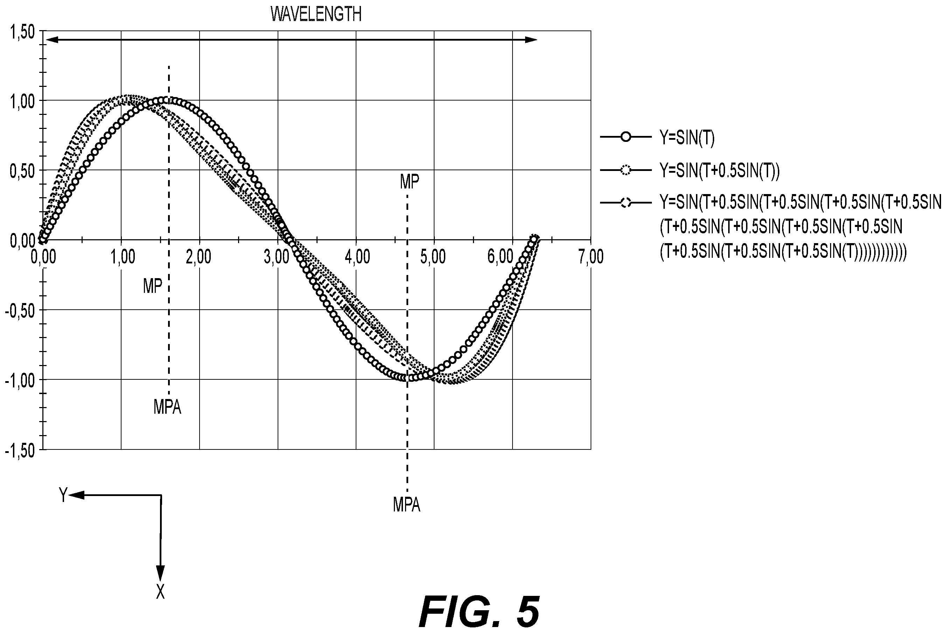

Referring now to Fig. 5, the perimeter shape 155 of each pin is defined, at least in part, by a nested trigonometric function including a factor of asymmetry. As will be explained below, the nested trigonometric function including a factor of asymmetry defines a spline which is used to both define the channels and to manufacture the pins and thereby defines at least a portion of the perimeter shape 155. In fact, in certain embodiments, the perimeter shape 155 of each pin 152 is defined in part by a method of creating channels (splines) which are themselves defined by the nested trigonometric function including a factor of asymmetry. The relative positions of adjacent splines leaves "islands" within the channels which are the pins.

In certain embodiments, the nested trigonometric function including a factor of asymmetry comprises:

$$y(t) = A + B * \sin(C * t + D + p * \sin(C * t + D + p * \sin(C * t + D + \dots)))$$

where y is at least a portion of the perimeter shape 155,
p is a factor of asymmetry between 0 and 0.5,
t is a parametric variable,
A is a lateral position of the longitudinal axis and may be used to adjust a width of the pins 152,
B is a lateral amplitude of the at least a portion of the perimeter shape 155,
C is longitudinal length and wavelength, and
D is an optional term to longitudinally offset the at least a portion of the perimeter shape 155.

It will be appreciated that the nested trigonometric function above can also be expressed using cosine instead of sine, using a factor $\pi/2$.

In yet other embodiments, any other nested trigonometric function including a factor of asymmetry, or other mathematical expressions with comparable results, can be used to define a trigonometric form with an asymmetric form (i.e. the spline). Portions of the spline can be used to define the perimeter shape 155. For example, a function series of different sinus terms (e.g. truncated Fourier series). One example is:

$$\sum_{k=1}^{n} A_k(n) * \frac{\sin(k*t)}{k}$$

with $A_k(n)$ coefficients depending on k and n.

As can be seen in Fig. 5, a conventional sinus wave comprises a half wavelength in the form of a positive parabola and another half waveform in the form of a negative parabola. The conventional sinus wave has a wavelength $\lambda$, with a peak of each parabola occurring at a midway point MP along the given parabola (which is equivalent to ¼ of the total wavelength $\lambda$). Each parabola is symmetrical about a midway point axis MPA extending through the midway point MP.

According to embodiments of the present technology, adding a factor of asymmetry, p, to a nested sine function, such as y=sin(t+0.5.sin(t)), shifts the peaks of the parabolas away from the midway point MP, such that the parabola is no longer symmetrical about the midway point axis MPA. Further nested sine functions change the asymmetry of the parabolas further.

Referring back to Fig. 4, the perimeter shape 155 of the pin 152 comprises a first side 155a and a second side 155b which are mirror images of each other about the longitudinal passage axis 148. Each of the first and second sides 155a, 155b extend between the tail and head ends 158, 160. With reference to Fig. 5, the first side 155a is defined by the positive parabola of the nested sine function including the parameter of asymmetry, and the second side is defined by the negative parabola of the nested sine function including the parameter of asymmetry rotated by 180 degrees.

As stated earlier, the profile of the rounded sections 144 of the internal sidewalls 140, 142 may be defined by the nested sine function including the parameter of asymmetry, as described for the pins 152. In other embodiments, the profile of the rounded sections 144 of the internal sidewalls 140 may be defined as a function of the shape of the pins 152, such as having a predefined distance from the pins. In this way, the profile of the rounded section 144 will follow that of the pins 152.

As will be explained in further detail below, this is a result of the method of manufacture which comprises forming channels which follow a path defined by the nested sine function including the parameter of asymmetry. The rounded sections 144 of the internal sidewalls 140 are thus also defined by the nested sine function including the parameter of asymmetry.

Returning to Fig. 3, in this embodiment, the fluid conduit 115 has seven passages 130 extending parallel to each other, each passage 130 being defined in part by a corresponding pin row 150. It is contemplated that more or fewer passages 130 could be provided in other embodiments. Furthermore, in this embodiment, the constricted and expanded portions 154, 156 of consecutive ones of the passages 130 are offset from each other in the longitudinal direction. That is, the constricted portions 154 of the given passage 130 is offset, in the longitudinal direction, from the constricted portions 154 of another passage 130 that is consecutive to the given passage 130. Rather, the constricted portions 154 of the given passage 130 are substantially aligned, in the longitudinal direction, with the expanded portions 156 of the other consecutive passage 130. As such, the pins 152 of consecutive ones of the pin rows 150 (defining consecutive ones of the passages 130 respectively) are offset from each other along the longitudinal direction. Notably, a center point 157 of each pin 152 of a first pin row 150 (located at midlength between the tail and head ends 158, 160 of the pin 152) is offset from the center point 157 of each pin 152 of a second pin row 150 that is consecutive to the first pin row 150. This may be helpful to more closely pack together the passages 130 which can increase the amount of pins 152 defining the fluid conduit 115 and also optimize the longitudinal distribution of a thickness of the material between consecutive passages 130, thereby optimizing the cooling provided by the cooling block 100.

This configuration of the pins 152 can promote turbulent flow while, in some cases, limiting flow separation and recirculation of the cooling fluid as it flows through the fluid conduit 115, contrary to many conventional fluid conduit designs including turbulators. In turn, this increases the heat absorbing capability of the cooling fluid which can therefore dissipate heat more efficiently from the heat-generating electronic component 50,

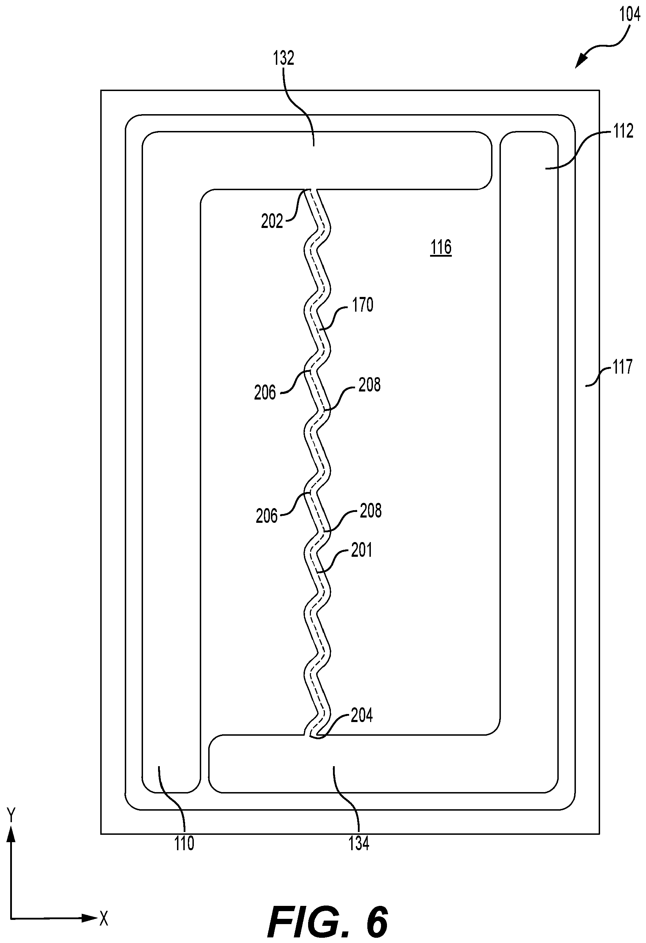

The manner in which the base 104 is manufactured will now be described with reference to Figs. 6 to 8 which illustrate the progressive forming of the passages 130. The fluid conduit 115 is machined, namely milled, onto a piece of material to form the finished base 104. In this example, the inlet and outlet manifold portions 132, 134 are already formed prior to machining the passages 130. It is contemplated that the inlet and outlet manifold portions 132, 134 may not yet be formed prior to machining the passages 130. In other embodiments, the inlet and outlet manifold portions 132, 134 may be entirely omitted. As shown in Fig. 6, in order to form the passage 130, a first channel 170 is milled on the upper surface 116 of the base 104 following a path defined by a sinusoidal spline 201, the sinusoidal spline 201 defined by the nested sine function including the asymmetry parameter. The sinusoidal spline 201 extends in a longitudinal direction of the cooling block 100 from a first end 202 to a second end 204. In this embodiment, the first end 202 is located at an edge of the inlet manifold portion 132 and the second end 204 is located at an edge of the outlet manifold portion 134 such that the resulting first channel 170 interconnects the inlet and outlet manifold portions 132, 134. The sinusoidal spline 201 comprises an alternating series of positive and negative parabolas, each parabola having a given amplitude and a given wavelength and defining a plurality of negative peaks 206 and positive peaks 208, with each peak 206, 208 shifted relative to the mid-length of the parabola in the longitudinal direction.

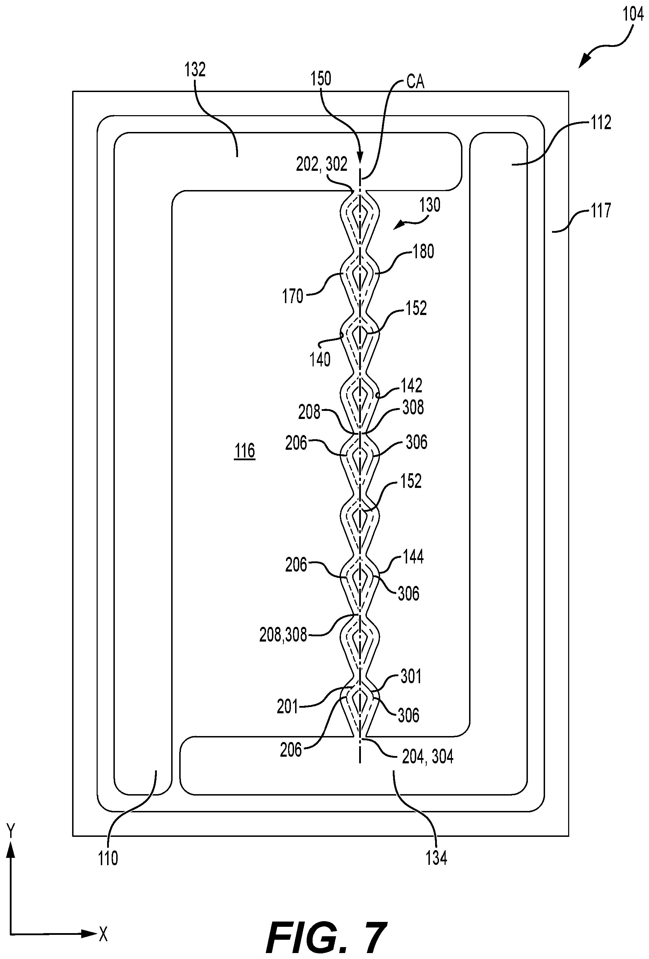

Next, as shown in Fig. 7, a second channel 180 is milled on the upper surface 116 of the base 104 following a path defined by another sinusoidal spline 301. The milling of the channels 170, 180 forms a corresponding pin row 150 as described above. The sinusoidal spline 301 extends in the longitudinal direction of the cooling block 100 from a first end 302 to a second end 304. In this embodiment, the first end 302 is located at an edge of the inlet manifold portion 132 and the second end 304 is located at an edge of the outlet manifold portion 134 such that the resulting second channel 180 interconnects the inlet and outlet manifold portions 132, 134. The sinusoidal spline 301 is defined by the nested sine function including the asymmetry parameter. The sinusoidal spline 301 comprises an alternating series of positive and negative parabolas, each parabola having a given amplitude and a given wavelength, which defines a plurality of positive peaks 306 and negative peaks 308, with each peak 306, 308 shifted relative to the mid-length of the parabola in the longitudinal direction. The amplitude and the wavelength of the sinusoidal spline 301 are the same as the amplitude and the wavelength of the sinusoidal spline 201.

As will be appreciated, in this embodiment, the sinusoidal spline 301 is completely out of phase with the sinusoidal spline 201 (i.e., 180° out of phase along the longitudinal direction). The positive peaks 306 are paired and aligned, in the longitudinal direction, with the negative peaks 206 while being on opposite sides of the longitudinal passage axis 148 about which the sinusoidal splines 201, 301 are mirrored. In the context of the present disclosure, peaks that are aligned in the longitudinal directions implies that those peaks are laterally spaced along a lateral direction (or axis). Said spacing may or may not include a lateral spacing (laterally off-set).

Similarly, each of the negative peaks 308 of the sinusoidal spline 301 is paired and longitudinally aligned with a respective positive peak 208 of the sinusoidal spline 201. The peaks 206, 306 have a larger lateral spacing compared to the peaks 208, 308. In some embodiments, the peaks 208, 308 are coincident. At the peaks, tangent lines to the splines 201, 301 are parallel to the longitudinal axis, and thus when the peaks 208, 308 are coincident, the tangent lines are also coincident. In other embodiments, the peaks 208, 308 are laterally off-set. In such embodiments, the tangent lines at the peaks 208, 308 are also off-set. In this illustrative implementation, it can be said that peaks 202 and 204 are first and last of a series of positive peaks 208, and that peaks 302 and 304 are first and last of a series of negative peaks 308.

In the embodiment of Fig. 7, the first end 302 of the sinusoidal spline 301 is coincident with the first end 202 of the sinusoidal spline 201, and the second end 304 of the sinusoidal spline 301 is coincident with the second end 204 of the sinusoidal spline 201. The first ends 202, 302 of the channels 170, 180, and the second ends 204, 304 of the channels 170, 180 may not be coincident in other embodiments (e.g. the first ends 202, 302 of the channels 170, 180, and the second ends 204, 304 of the channels 170, 180 may laterally offset).

As can be seen, the sinusoidal splines 201, 301 are arranged such that the resulting first and second channels 170, 180 are interconnected to each other such that, in use, cooling fluid flowing within the passage 130 flows in both the first and second channels 170, 180. Notably, as will be appreciated, the channels 170, 180 form the opposite internal sidewalls 140, 142 of the passage 130 and the catenulate shape thereof. As shown in Fig. 7, in this embodiment, the sinusoidal splines 201, 301 are symmetric about a linear axis CA extending in the longitudinal direction which, once the channels 170, 180 are formed, corresponds to the longitudinal passage axis 148.

After having milled the two channels 170, 180, the first passage 130 of the fluid conduit 115 is formed. The other passages 130 are then formed in the same manner.

The channels 170, 180 are milled using a milling cutter and have a relatively small width. For instance, in this example, the channels 170, 180 have a width of approximately 1.5 mm or about 2 mm. Moreover, in this embodiment, each channel 170, 180 is formed by cutting into the surface 116 of the base 104 along the corresponding sinusoidal spline 201, 301. In other words, the milling cutter does not need to divert from either of the sinusoidal splines 201, 301 as it mills the respective channels 170, 180. For instance, each of the channels 170, 180 could be formed by milling along the corresponding sinusoidal spline 201, 301 a single time (i.e., in a single pass along each sinusoidal spline 201, 301). In some cases where the height of the channels 170, 180 is more significant (e.g., greater than the widths of the channels 170, 180), additional passes may be made at a different height following the same paths described by the sinusoidal splines 201, 301. Notably, in this embodiment, the width of each channel 170, 180 corresponds to the diameter of the milling cutter. Milling the channels 170, 180 is relatively simple as it does not require extensive tooling as might be the case for example for forming "micro" passages that have a microscopic width (e.g., 0.5 mm). Indeed, milling micro passages that are less than 1 mm wide can require more specialized tooling (e.g., a micro mill and associated micro milling cutters) and, moreover, typically requires significantly more passes to mill to a desired depth since the milling cutters cannot safely and/or cleanly cut a thickness of material that is deeper than the diameter of the milling cutter. In addition, micro milling cutters can have a greater tendency to break during use.

In some embodiments, when there is no lateral off-set between the peaks 208, 308, an amplitude of the sinusoidal splines 201, 301 is equal to a sum of a radius of the milling cutter and half of the width of the pins 152.

During the milling of the channels of the passages 130, some material (e.g. copper) chips may be not properly evacuated and may stay attached to the cooling block being manufactured. In such cases, an additional step in the manufacturing process using a finisher cutter is necessary. In certain embodiments, this step may be combined by milling the sharp edges of the pins to obtain rounded head ends and, optionally, rounded tail ends.

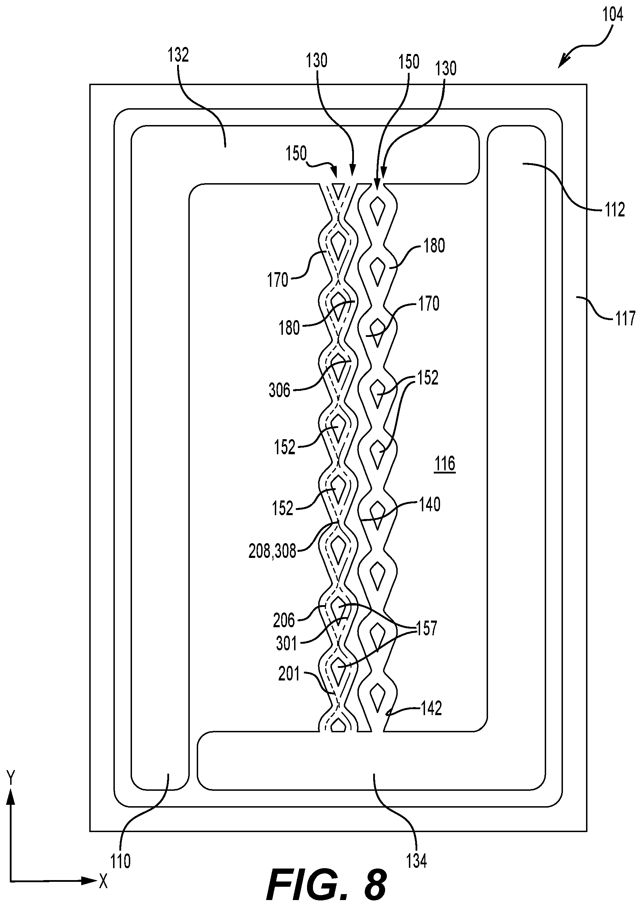

As shown in Fig. 8, once the first passage 130 is formed, a second passage 130 adjacent to the first passage 130 is formed. The second passage 130 is formed in the same manner as the first passage 130 as described above. Of course, it is contemplated that, in some embodiments, only a single passage 130 could be formed. As shown in Fig. 8, in this embodiment, the sinusoidal splines 201, 301 along which the channels 170, 180 forming the second passage 130 are milled are positioned such that the pins 152 of the pin row 150 defining the second passage 130 are offset in the longitudinal direction from the pins 152 defining the first passage 130. That is, the center point 157 of each pin 152 in the second pin row 150 is offset from the center point 157 of each pin 152 in the first pin row 150.

The other passages 130 of the fluid conduit 115 are then milled in the same manner as described above for the first two passages 130 until the finished base 104 is obtained.

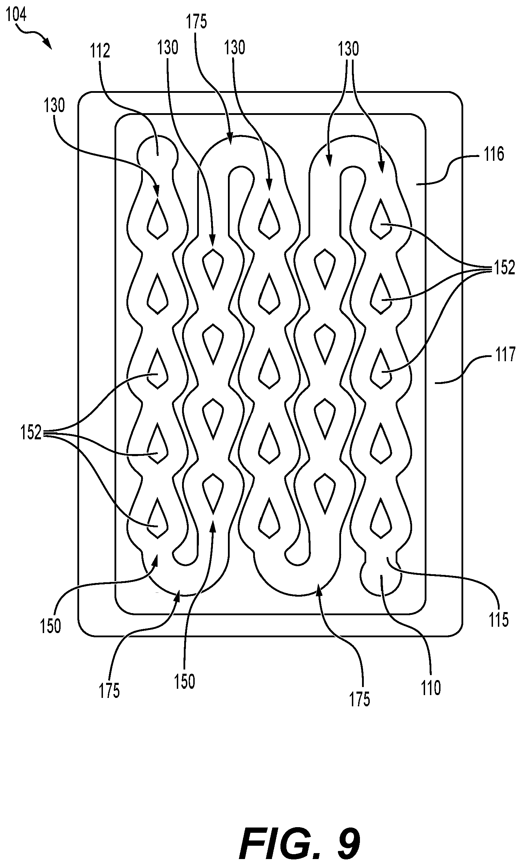

With reference to Fig. 9, in an alternative embodiment, the fluid conduit 115 could be configured differently and still have the passages 130 as described above. In particular, in Fig. 9, the base 104 is shaped differently and the fluid conduit 115 includes five passages 130 which are fluidly connected to each other and disposed parallel to one another. In this alternative embodiment, the passages 130 are fluidly connected to each other in series by interconnecting portions 175 of the fluid conduit 115. Notably, in this example, each interconnecting portion 175 is disposed between two consecutive passages 130 such that the cooling fluid flows into a given interconnecting portion 175 before flowing into another passage 130. The interconnecting portions 175 may be configured differently in other embodiments. The base 104 shown in Fig. 9 is manufactured in a manner similar to that described above. In this embodiment, the pins 152 on the adjacent passage 130 have a head-to-toe orientation or have a different longitudinal orientation. This configuration combined with an adequate longitudinal offset enable to closely align, in the longitudinal direction, the constricted portions 154 of the given passage 130, with the expanded portions 156 of the other consecutive passage 130, thus optimizing the longitudinal distribution of a thickness of the material between consecutive passages 130. This may also allow the passages 130 to be disposed closer to one another, in the lateral direction. The cooling efficiency of the cooling block 100 may be optimized by positioning the passages 130 closer to each other. In other embodiments, the pins 152 of the different passages 130 may have the same longitudinal orientation.

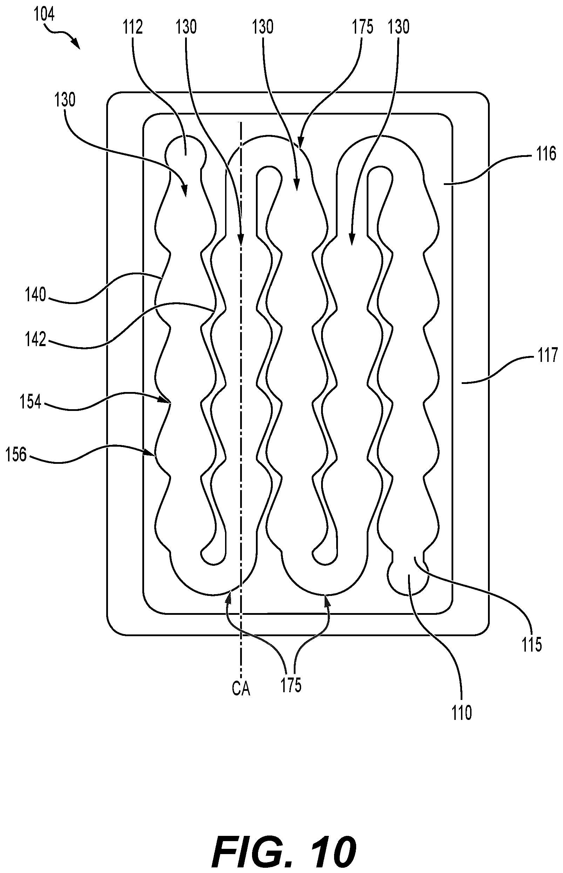

As shown in Fig. 10, in an example which does not form part of the invention but useful to understand it, the pins 152 may be omitted. As can be seen, in this embodiment, the base 104 is similar to that shown in Fig. 9 except that the pins 152 are not provided. Thus, in this example, each passage 130 is defined by the opposite internal sidewalls 140, 142 and includes the constricted portions 154 and the expanded portions 156 disposed alternatingly. In this embodiment, the base 104 is manufactured in a manner similar to that described above, however with the additional step of milling the base 104 to remove the pins 152 once the pins 152 are formed. For example, this could involve milling the base 104 along the central linear axis CA of each respective passage 130 such as to eliminate the pins 152.

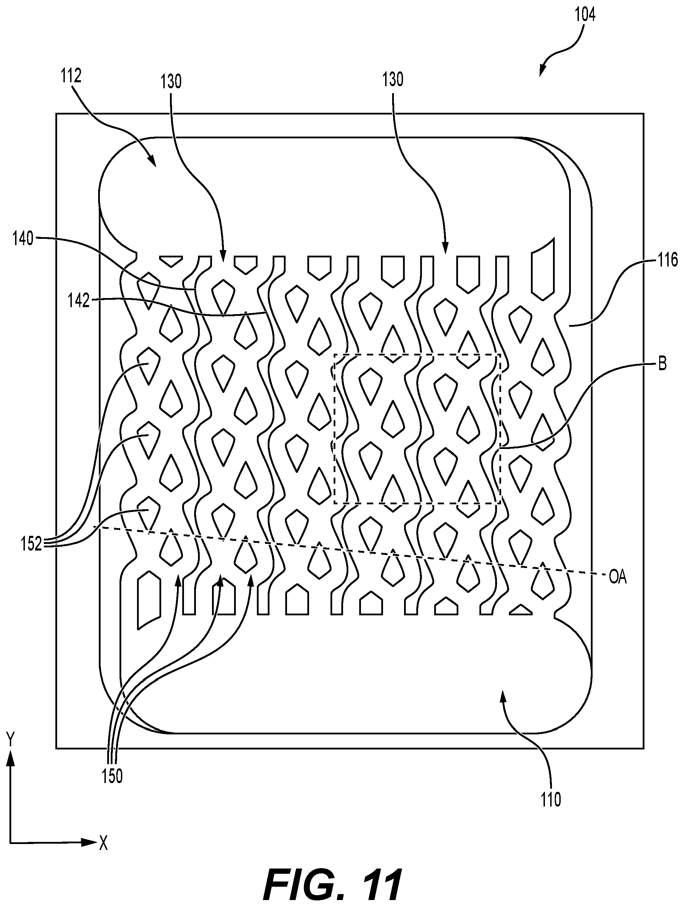

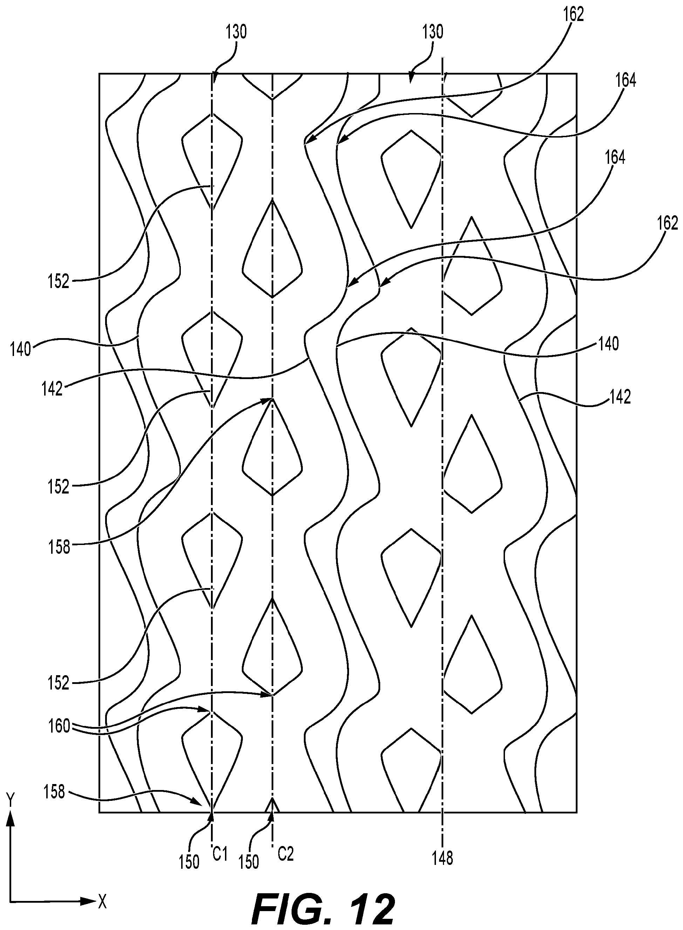

In some embodiments, each passage 130 may be defined by more than one pin row 150. Notably, with reference to Figs. 11 and 12, in another embodiment, each passage 130 is defined in part by first and second pin rows 150 disposed between the internal sidewalls 140, 142 of the passage 130. As shown in Fig. 12, in this example, for each pin row 150, the pins 152 thereof are laterally aligned with each other such that a corresponding linear axis C1, C2 extending in the longitudinal direction traverses each pin 152. The linear axes C1, C2 are laterally spaced from each other. In this example, each linear axis C1, C2 extends through the tail and head ends 158, 160 of each pin 152 of the corresponding pin row 150 as the pins 152 are symmetric about the respective linear axes C1, C2. In this embodiment, the pins 152 of the first pin row 150 are offset from the pins 152 of the second pin row 150 in the longitudinal direction.

With reference to Fig. 12, in this embodiment, each internal sidewall 140, 142 has an undulating shape (i.e., a wave-like shape) and therefore has a plurality of rounded sections. More specifically, the rounded sections of each internal sidewall 140, 142 are a plurality of convex undulations 162 and a plurality of concave undulations 164 disposed alternatingly. Notably, each internal sidewall 140, 142 has a sinusoidal shape describing a sinusoidal function which may be the nested trigonometric function having the asymmetry parameter. As can be seen, in this embodiment, for each passage 130, the convex undulations 162 of the internal sidewall 140 are substantially aligned, in the longitudinal direction, with the concave undulations 164 of the opposite internal sidewall 142 such that their respective peaks are substantially longitudinally aligned. As such, the internal sidewalls 140, 142 defining each passage 130 are asymmetric about the longitudinal passage axis 148 bisecting the width of the passage 130.

Furthermore, in the example of Fig. 12, for each two consecutive passages 130, the internal sidewall 140 defining the first passage 130 is adjacent to the internal sidewall 142 defining the second passage 130 consecutive to the first passage 130, and the concave undulations 164 of the internal sidewall 140 defining the first passage 130 are substantially aligned, in the longitudinal direction, with the convex undulations 162 of the internal sidewall 142 defining the second passage 130. Notably, the consecutive passages 130 may be longitudinally off-set defined by an off-set axis OA (shown on Fig. 11), which enables to closely align, in the longitudinal direction, concave undulations 164 of the internal sidewall 140 defining the first passage 130, with the convex undulations 162 of the internal sidewall 142 defining the second passage 130, thus optimizing the longitudinal distribution of a thickness of the material between consecutive passages 130. This may also allow the passages 130 to be disposed closer to one another, in the lateral direction. The cooling efficiency of the cooling block 100 may be optimized by positioning the passages 130 closer to each other.

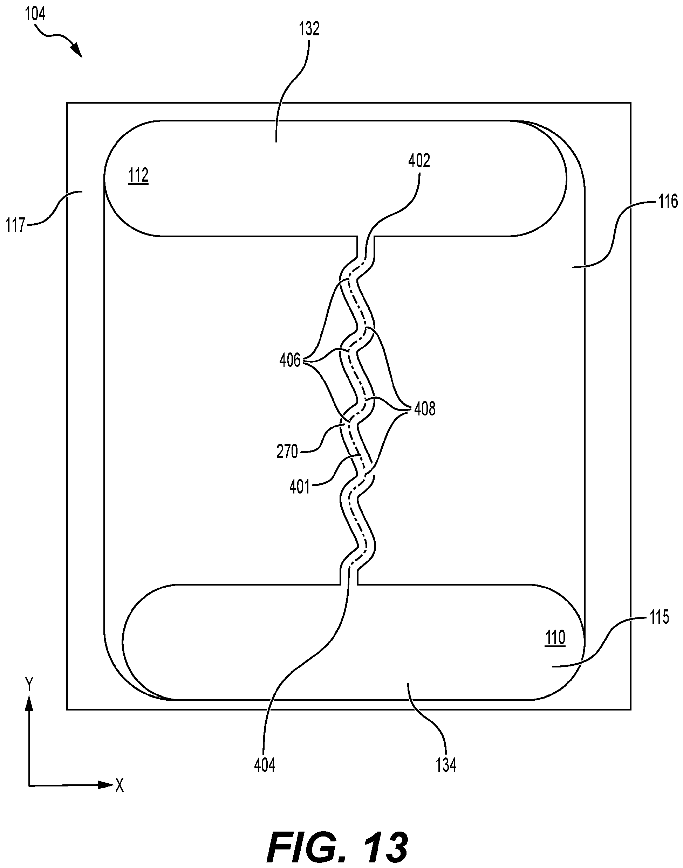

The manner in which the base 104 of Fig. 11 is manufactured will now be described with reference to Figs. 13 to 15 which illustrate the progressive forming of the passages 130. Similarly to that described above, the fluid conduit 115 is machined, namely milled, onto a piece of material to form the finished base 104. In this example, the inlet and outlet manifold portions 132, 134 are already formed prior to machining the passages 130. It is contemplated that the inlet and outlet manifold portions 132, 134 may not yet be formed prior to machining the passages 130. In other embodiments, the inlet and outlet manifold portions 132, 134 may even be entirely omitted. As shown in Fig. 13, in order to form a first passage 130, a first channel 270 is milled on the upper surface 116 of the base 104 following a path defined by a sinusoidal spline 401. The sinusoidal spline 401 extends in a longitudinal direction of the cooling block 100 from a first end 402 to a second end 404. In this embodiment, the first end 402 is located at an edge of the inlet manifold portion 132 and the second end 404 is located at an edge of the outlet manifold portion 134 such that the resulting first channel 270 interconnects the inlet and outlet manifold portions 132, 134. The sinusoidal spline 401 has the shape of a nested trigonometric function with a parameter of asymmetry: an alternating series of positive and negative parabolas, each parabola having a given amplitude and a given wavelength. The sinusoidal spline 401 defines a plurality of negative peaks 406 and positive peaks 408, with each peak 406, 408 shifted relative to the mid-length of the parabola in the longitudinal direction.

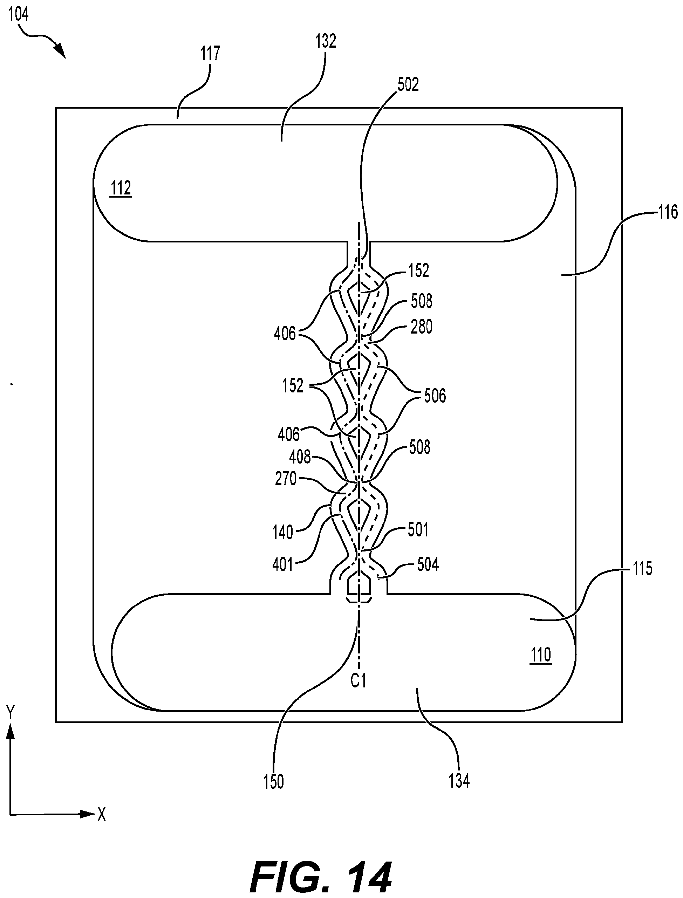

Next, as shown in Fig. 14, a second channel 280 is milled on the upper surface 116 of the base 104 following a path defined by another sinusoidal spline 501. The milling of the channels 270, 280 forms a first pin row 150 as described above. The sinusoidal spline 501 extends in the longitudinal direction of the cooling block 100 from a first end 502 to a second end 504. In this embodiment, the first end 502 is located at an edge of the inlet manifold portion 132 and the second end 504 is located at an edge of the outlet manifold portion 134 such that the resulting second channel 280 interconnects the inlet and outlet manifold portions 132, 134. The sinusoidal spline 501 has the shape of a nested trigonometric function having a parameter of asymmetry: an alternating series of positive and negative parabolas, each parabola having a given amplitude and a given wavelength (namely the same amplitude and the same wavelength as the parabolas of the sinusoidal spline 401) and defining a plurality of positive peaks 506 and negative peaks 508 at each period thereof.

As will be appreciated, in this embodiment, the sinusoidal splines 401, 501 are centered (and oscillate) about different axes, namely two distinct linear axes extending in the longitudinal direction and spaced apart from each other in the lateral direction. The sinusoidal spline 501 is completely out of phase with the sinusoidal spline 401 (i.e., 180° out of phase along the longitudinal direction). Notably, the positive peaks 506 of the sinusoidal spline 501 are paired and aligned, in the longitudinal direction, with the negative peaks 406 of the sinusoidal spline 401 and are symmetric to each other about a linear axis extending in the longitudinal direction which, once the channels 270, 280 are formed, corresponds to the linear axis C1 aligned with the head end and tail end of each pin of the first pin row 150.

Similarly, each of the negative peaks 508 of the sinusoidal spline 501 is paired and aligned, in the longitudinal direction, with a respective positive peak 408 of the sinusoidal spline 401. The peaks 406, 506 have a greater lateral spacing compared to the peaks 408, 508.

In some embodiments, the peaks 408, 508 are coincident. At the peaks, tangent lines to the splines 401, 501 are parallel to the longitudinal axis, and thus when the peaks 408, 508 are coincident, the tangent lines are also coincident. In other embodiments, the peaks 408, 508 are laterally off-set. In such embodiments, the tangent lines at the peaks 408, 508 are also off-set.

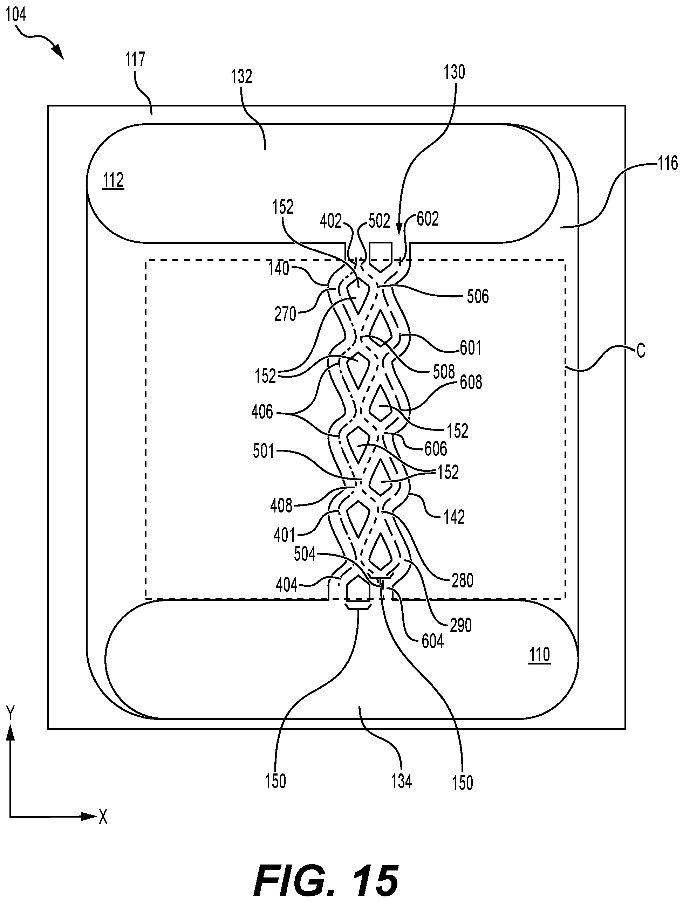

With reference to Fig. 15, after having milled the second channel 280, a third channel 290 is milled on the upper surface 116 of the base 104 following a path defined by another sinusoidal spline 601 defined by a nested trigonometric function including a parameter of asymmetry. In other embodiments, the channels 270, 280, 290 may be milled in a different order (e.g., the second channel 280 could be milled after the third channel 290). The milling of the third channel 290, combined with the milling of the second channel 280, forms a second pin row 150 as described above.

The sinusoidal spline 601 extends in the longitudinal direction of the cooling block 100 from a first end 602 to a second end 604. In this embodiment, the first end 602 is located at an edge of the inlet manifold portion 132 and the second end 604 is located at an edge of the outlet manifold portion 134 such that the resulting third channel 290 interconnects the inlet and outlet manifold portions 132, 134. The sinusoidal spline 601 has the shape of a nested trigonometric function having a parameter of asymmetry: an alternating series of positive and negative parabolas, each parabola having a given amplitude and a given wavelength (namely the same amplitude and the same wavelength as the parabolas of the sinusoidal splines 401, 501) and defining a plurality of negative peaks 606 and positive peaks 608 at each period thereof.

As will be appreciated, in this embodiment, the sinusoidal splines 401, 501, 601 are centered (and oscillate) about different axes, namely three distinct linear axes extending in the longitudinal direction and spaced apart from each other in the lateral direction. The sinusoidal spline 601 is completely out of phase with the sinusoidal spline 501 (i.e., 180° out of phase along the longitudinal direction) but in phase with the sinusoidal spline 401. Notably, the sinusoidal splines 501, 601 are symmetric to each other about a linear axis extending in the longitudinal direction which, once the channels 280, 290 are formed, corresponds to the linear axis C2 aligned with the head end and tail end of each pin of the second pin row 150, however the sinusoidal splines 401, 601 are not symmetric to each other about a linear axis as the sinusoidal spline 601 is identical to the sinusoidal spline 401 but shifted relative thereto in the lateral direction.

The negative peaks 606 of the sinusoidal spline 601 are aligned, in the longitudinal direction, with the peaks 406, 506 of the sinusoidal splines 401, 501. The positive peaks 608 of the sinusoidal spline 601 are longitudinally aligned with the peaks 408, 508 of the sinusoidal splines 401, 501. Moreover, each negative peak 606 of the sinusoidal spline 601 is paired with a positive peak 506 of the sinusoidal spline 501, and each positive peak 608 of the sinusoidal spline 601 is paired with a negative peak 508 of the sinusoidal spline 501.

In some embodiments, the peaks 506, 606 are coincident. At the peaks, tangent lines to the splines 501, 601 are parallel to the longitudinal axis, and thus when the peaks 506, 606 are coincident, the tangent lines are also coincident. In other embodiments, the peaks 506, 606 are laterally off-set. In such embodiments, the tangent lines at the peaks 506, 606 are also off-set.

After having milled all three channels 270, 280, 290, the first passage 130 of the fluid conduit 115 is formed. The other passages 130 are then formed in the same manner.

The channels 270, 280, 290 are milled using a milling cutter and have a relatively small width. For instance, in this example, the channels 270, 280, 290 have a width of approximately 1.5 mm or approximately 2 mm. Moreover, in this embodiment, each channel 270, 280, 290 is formed by cutting into the surface 116 of the base 104 along the corresponding sinusoidal spline 401, 501, 601. In other words, the milling cutter does not need to divert from any of the sinusoidal splines 401, 501, 601 as it mills the respective channels 270, 280, 290. For instance, each of the channels 270, 280, 290 could be formed by milling along the corresponding sinusoidal spline 401, 501, 601 a single time (i.e., in a single pass along each sinusoidal spline 401, 501, 601). In some embodiments, more than a single pass along each sinusoidal spline 401, 501, 601 may be effected depending on the desired depth of the channels 270, 280, 290. In this embodiment, the width of each channel 270, 280, 290 corresponds to the diameter of the milling cutter.

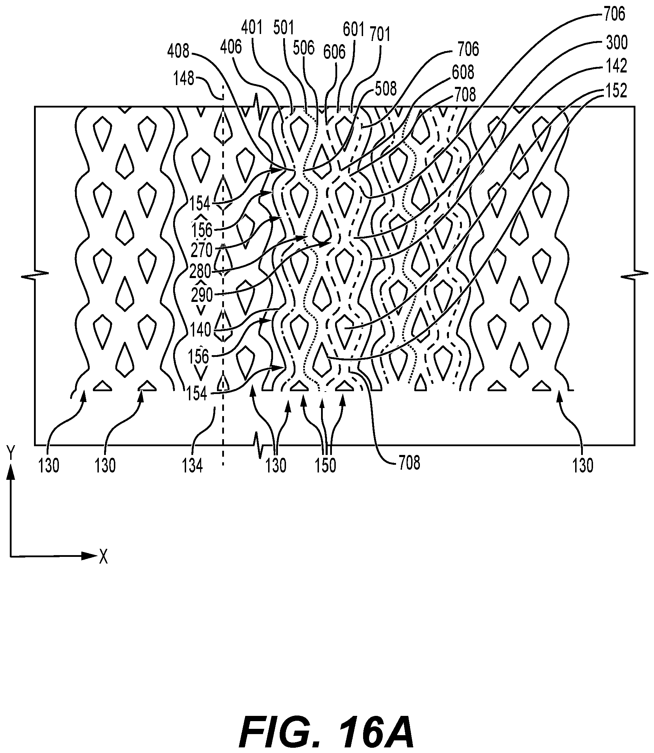

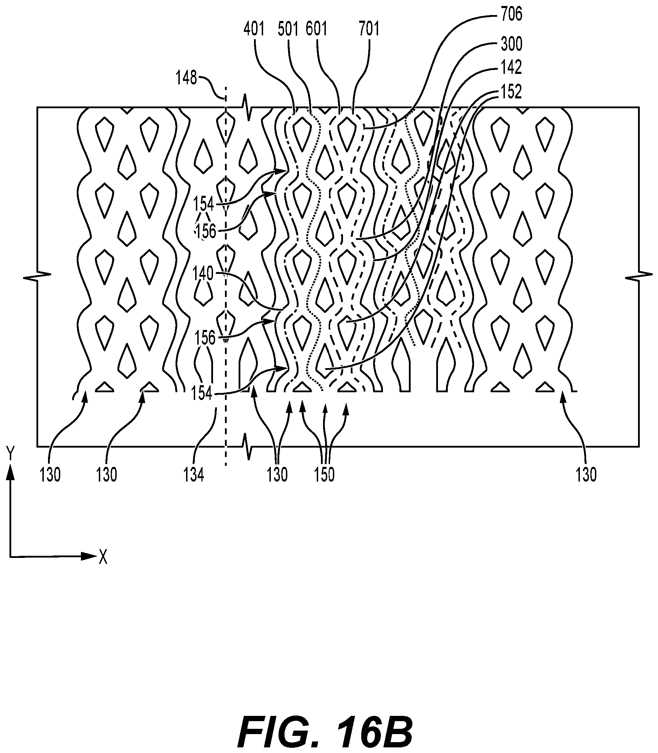

Alternative embodiments of the configuration of box C of Fig. 15 are shown in Fig. 16A and 16B. Each passage 130 is defined in part by three pin rows 150. For each pin row 150, the pins 152 thereof are aligned in the lateral direction such that a respective linear axis traverses the pins 152 of the pin row 150. For each two consecutive pin rows 150 defining the passage 130 (i.e., the pin rows 150 consecutive to each other in the lateral direction), the pins 152 of a first pin row 150 are offset in the longitudinal direction from the pins 152 of a second pin row 150 consecutive to the first pin row 150, and the pins 152 of a first pin row 150 have a different longitudinal orientation from the pins 152 of a second pin row 150 consecutive to the first pin row 150. As can be seen, in this embodiment, when the number of the pin rows 150 is odd (as opposed to even), the internal sidewalls 140, 142 of the passage 130 are symmetric to each other about the longitudinal passage axis 148 extending longitudinally and bisecting the width of the passage 130. Furthermore, each passage 130 includes the constricted portions 154 and the expanded portions 156 disposed alternatingly, whereby the expanded portions 156 have a width (measured in the lateral direction) greater than that of the constricted portions 154. The pins 152 of the two "outer" pin rows 150 that are closest to the internal sidewalls 140, 142 are disposed in the expanded portions 156, while the pins 152 of the "inner" pin row 150 disposed between the two outer pin rows 150 are disposed in the constricted portions 154. With reference to Fig. 16A, the pins 152 of the different passages 130 have the same longitudinal orientation.

The configuration of the passages 130 can be obtained by forming a fourth channel 300 interconnected with the other channels 270, 280, 290. In particular, the fourth channel 300 is milled on the upper surface 116 of the base 104 following a path defined by another sinusoidal spline 701. The milling of the fourth channel 300, combined with the milling of the third channel 290, forms a third pin row 150 of the type described above. The sinusoidal spline 701 is identical to the sinusoidal spline 501 but shifted relative thereto in the lateral direction. As will be appreciated, the sinusoidal spline 701 has the shape of a nested trigonometric function having a parameter of asymmetry: an alternating series of positive and negative parabolas, each parabola having a given amplitude and a given wavelength (namely the same amplitude and the same wavelength as the parabolas of the sinusoidal splines 401, 501, 601) and defining a plurality of positive peaks 706 and negative peaks 708 at each period thereof.

The positive peaks 706 of the sinusoidal spline 701 are aligned, in the longitudinal direction, with the peaks 406, 506, 606 of the sinusoidal splines 401, 501, 601. The negative peaks 708 of the sinusoidal spline 701 are longitudinally aligned with the peaks 408, 508, 608 of the sinusoidal splines 401, 501, 601. Moreover, each positive peak 706 of the sinusoidal spline 701 is paired with a negative peak 606 of the sinusoidal spline 601, and each negative peak 708 of the sinusoidal spline 701 is paired with a positive peak 608 of the sinusoidal spline 601.

In some embodiments, the peaks 608, 708 are coincident. At the peaks, tangent lines to the splines 601, 701 are parallel to the longitudinal axis, and thus when the peaks 608, 708 are coincident, the tangent lines are also coincident. In other embodiments, the peaks 608, 708 are laterally off-set. In such embodiments, the tangent lines at the peaks 608, 708 are also off-set.

The embodiment of Fig. 16B differs from that of Fig. 16A in that the pins 152 on adjacent passages 130 have a head-to-toe orientation (i.e. a different longitudinal orientation). This configuration combined with an adequate longitudinal offset enable to closely align, in the longitudinal direction, the constricted portions 154 of the given passage 130, with the expanded portions 156 of the other consecutive passage 130, thus optimizing the longitudinal distribution of a thickness of the material between consecutive passages 130. This may also allow the passages 130 to be disposed closer to one another, in the lateral direction. The cooling efficiency of the cooling block 100 may be optimized by positioning the passages 130 closer to each other.

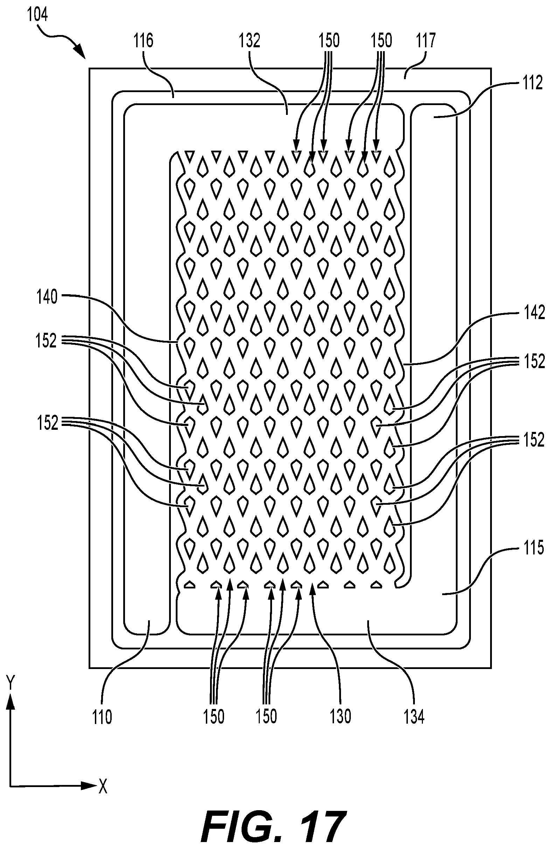

The passages 130 could be defined by any number of pin rows 150 in other embodiments. For instance, as shown in Fig. 17, in an alternative embodiment, the passage 130 of the fluid conduit 115 is defined by sixteen pin rows 150, the pins 152 of each pin row 150 being centered about a respective linear axis that traverses each pin 152 of the respective pin row 150. Moreover, as can be seen, in this alternative embodiment, the fluid conduit 115 has a single passage 130 such that an entire proportion of the cooling fluid flows from the inlet manifold portion 132 to the outlet manifold portion 134 via the single passage 130.

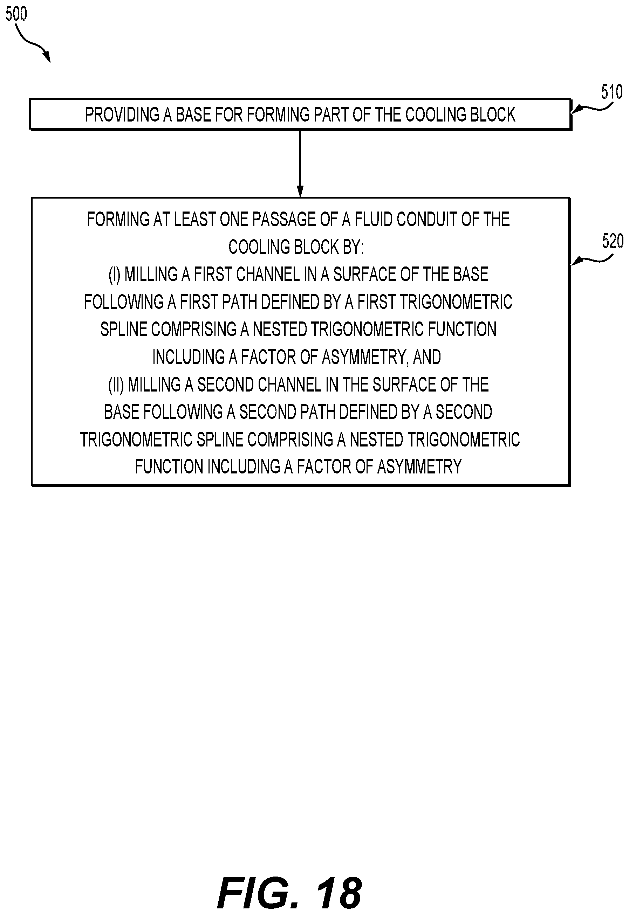

Fig. 18 illustrates a method 500 for manufacturing a cooling block, such as the cooling block 100, configured to cool a heat-generating electronic component. The method 500 comprises Step 510 providing a base for forming part of the cooling block. The base may comprise the base 104 described above. In Step 520, the method 500 comprises forming at least one passage of a fluid conduit of the cooling block by: milling a first channel in a surface of the base following a first path defined by a first trigonometric spline, the first trigonometric spline defined by a nested trigonometric function including a factor of asymmetry; milling a second channel in the surface of the base following a second path defined by a second sinusoidal spline, the second sinusoidal spline defined by the nested trigonometric function including the factor of asymmetry, the first and second sinusoidal splines extending in a longitudinal direction of the cooling block and being arranged such that the first channel and the second channel are interconnected to each other such that, in use, cooling fluid flowing within the passage flows within the first channel and the second channel; said milling of the first and second channels forming the at least one passage having a plurality of pins spaced from each other as a pin row along the longitudinal direction.

**Claims**

1. A cooling block (100) for cooling a heat-generating electronic component (50), the cooling block (100) comprising a body having defined therein a fluid conduit (115) for circulating a cooling fluid therethrough, the fluid conduit being defined by at least one passage (130) extending between an inlet point (110) and an outlet point (112), the at least one passage (130) comprising:

a longitudinal passage axis;
first and second internal sidewalls (140, 142) defining the at least one passage (130);
a plurality of pins (152) disposed between the internal sidewalls (104, 142) for deflecting the cooling fluid flowing within the at least one passage (130), each pin (152) having a head end (160) and a tail end (158), and the plurality of pins (152) being disposed as a pin row in the at least one passage (130) with the head end (160) and the tail end (158) of each pin (152) disposed along the longitudinal passage axis,
wherein at least a portion of a perimeter shape of each pin (152) is defined by a nested trigonometric function including a factor of asymmetry, the nested trigonometric function including a factor of asymmetry defining a spline which is used to manufacture the pin (152)

2.  The cooling block of claim 1, wherein the nested trigonometric function comprises a sinusoidal function.

3.  The cooling block of claim 1 or claim 2, wherein the perimeter shape of each pin is symmetric about the longitudinal passage axis, and is asymmetric about a lateral axis extending through the pin.

4.  The cooling block of any of claims 1-3, wherein the perimeter shape of each pin has a first side and a second side, the first and second sides being disposed on either side of the longitudinal passage axis, each of the first side and the second side being defined by half a wavelength of the nested trigonometric function including the factor of asymmetry.

5.  The cooling block of any of claims 1-4, wherein the longitudinal passage axis is a central linear axis of the at least one passage.

6.  The cooling block of any of claims 1-5, wherein each pin is oriented such that the tail end is downstream from the head end.

7.  The cooling block of any of claims 1-6, wherein the at least one passage has a plurality of expanded portions and a plurality of constricted portions distributed alternatingly with the expanded portions in the longitudinal direction;

the expanded portions have a first width measured in the lateral direction;
the constricted portions have a second width in the lateral direction;
the first width is greater than the second width; and
the pins are disposed in the expanded portions.

8.  The cooling block of any of claims 1-7, wherein the first and second internal sidewalls are symmetric to each other about the longitudinal passage axis.

9.  The cooling block of any of claims 1-8, wherein the first and second internal sidewalls are scalloped.

10. The cooling block of any of claims 1-9, the at least one passage comprising the plurality of pins comprises at least:

a first passage comprising a first plurality of pins, and
a second passage, adjacent to the first passage and laterally offset therefrom, comprising a second plurality of pins;
wherein the first plurality of pins is off-set from the second plurality of pins, along a longitudinal direction of the cooling block.

11. The cooling block of claim 10, wherein the fluid conduit comprises an inlet manifold portion and an outlet manifold portion, the first passage and the second passage extending between the inlet and outlet manifold portions.

12. The cooling block of any of claims 1-11, wherein:

the longitudinal passage axis of the at least one passage comprises:

a first longitudinal axis extending in a longitudinal direction, and

a second longitudinal axis extending in the longitudinal direction and parallel to the first longitudinal axis; and

the plurality of pins comprises:

a first set of pins having a first pin head end and a first pin tail end, the pins of the first set of pins being disposed in the at least one passage such that the first linear axis traverses the head end and the tail end of each pin of the first set of pins; and
a second set of pins having a second pin head end and a second pin tail end, the pins of the second set of pins being disposed in the at least one passage such that the second linear axis traverses the head end and the tail end of each pin of the second set of pins.

13. A method for manufacturing a cooling block (100) configured to cool a heat-generating electronic component (50), the method comprising:

providing a base for forming part of the cooling block (100);
forming at least one passage (130) of a fluid conduit of the cooling block (100) by:

milling a first channel (170) in a surface of the base following a first path defined by a first trigonometric spline, the first trigonometric spline defined by a nested trigonometric function including a factor of asymmetry;
milling a second channel (180) in the surface of the base following a second path defined by a second trigonometric spline, the second trigonometric spline defined by the nested trigonometric function including the factor of asymmetry, the first and second trigonometric splines extending in a longitudinal direction of the cooling block (100) and being arranged such that the first channel (170) and the second channel (180) are interconnected to each other such that, in use, cooling fluid flowing within the passage flows within the first channel (170) and the second channel (180);
said milling of the first and second channels forming the at least one passage (130) having a plurality of pins (152) spaced from each other as a pin row along the longitudinal direction.

14. The method of claim 13, wherein the at least one passage has a linear axis extending in the longitudinal direction, wherein the first trigonometric spline and the second trigonometric spline are symmetric about the linear axis.

15. The method of claim 14, wherein:

the first trigonometric spline extends from a first end to a second end;
the second trigonometric spline extends from a first end to a second end; and
the first or second end of the first trigonometric spline and the first or second end of the second trigonometric spline are coincident or laterally off-set.

**Patentansprüche**

1. Kühlblock (100) zur Kühlung eines wärmeerzeugenden elektronischen Bauteils (50), wobei der Kühlblock (100) einen Körper umfasst, der einen darin definierten Fluidleitung (115) zum Zirkulieren eines Kühlfluids aufweist, wobei die Fluidleitung durch mindestens einen Durchgang (130) definiert ist, der sich zwischen einem Einlasspunkt (110) und einem Auslasspunkt (112) erstreckt, wobei der mindestens eine Durchgang (130) Folgendes umfasst:

eine Längsachse des Durchgangs;
eine erste und eine zweite Innenseitenwand (140, 142), die den mindestens einen Durchgang (130) definieren;
eine Vielzahl von Stiften (152), die zwischen den Innenseitenwänden (104, 142) angeordnet ist, um das innerhalb des mindestens einen Durchgangs (130) strömende Kühlfluid abzulenken,
wobei jeder Stift (152) ein Kopfende (160) und ein Fußende (158) aufweist und
wobei die Vielzahl von Stiften (152) als eine Stiftreihe in dem mindestens einen Durchgang (130) angeordnet ist, wobei das Kopfende (160) und das Fußende (158) jedes Stifts (152) entlang der Längsachse des Durchgangs angeordnet sind,
wobei mindestens ein Abschnitt einer Umfangsform jedes Stifts (152) durch eine verschachtelte trigonometrische Funktion definiert ist, die einen Asymmetriefaktor beinhaltet, wobei die verschachtelte trigonometrische Funktion, die einen Asymmetriefaktor beinhaltet, einen Spline definiert, der verwendet wird, um den Stift (152) herzustellen.

**2.** Kühlblock nach Anspruch 1, wobei die verschachtelte trigonometrische Funktion eine Sinusfunktion umfasst.

**3.** Kühlblock nach Anspruch 1 oder 2, wobei die Umfangsform jedes Stifts um die Längsachse des Durchgangs symmetrisch ist und um eine sich durch den Stift erstreckende Querachse asymmetrisch ist.

**4.** Kühlblock nach einem der Ansprüche 1-3, wobei die Umfangsform jedes Stifts eine erste Seite und eine zweite Seite aufweist, wobei die erste Seite und die zweite Seite auf jeder Seite der Längsachse des Durchgangs angeordnet sind, wobei jede von der ersten Seite und der zweiten Seite durch eine halbe Wellenlänge der verschachtelten trigonometrischen Funktion, die den Asymmetriefaktors beinhaltet, definiert ist.

**5.** Kühlblock nach einem der Ansprüche 1-4, wobei die Längsachse des Durchgangs eine zentrale lineare Achse des mindestens einen Durchgangs ist.

**6.** Kühlblock nach einem der Ansprüche 1-5, wobei jeder Stift derart ausgerichtet ist, dass das Fußende stromabwärts von dem Kopfende liegt.

**7.** Kühlblock nach einem der Ansprüche 1-6, wobei der mindestens eine Durchgang eine Vielzahl von erweiterten Abschnitten und eine Vielzahl von verengten Abschnitten, die in der Längsrichtung abwechselnd mit den erweiterten Abschnitten verteilt ist, aufweist;

die erweiterten Abschnitte eine in der Querrichtung gemessene erste Breite aufweisen;
die verengten Abschnitte in der Querrichtung eine zweite Breite aufweisen;
die erste Breite größer als die zweite Breite ist; und
die Stifte in den erweiterten Abschnitten angeordnet sind.

**8.** Kühlblock nach einem der Ansprüche 1-7, wobei die erste und die zweite Innenseitenwand um die Längsachse des Durchgangs symmetrisch zueinander sind.

**9.** Kühlblock nach einem der Ansprüche 1-8, wobei die erste und die zweite Innenseitenwand bogenförmig sind.

**10.** Kühlblock nach einem der Ansprüche 1-9, wobei der mindestens eine Durchgang, der die Vielzahl von Stiften umfasst, mindestens Folgendes umfasst:

einen ersten Durchgang, der eine erste Vielzahl von Stiften umfasst, und
einen zweiten Durchgang benachbart zu dem ersten Durchgang und seitlich von diesem versetzt, der eine zweite Vielzahl von Stiften umfasst;
wobei die erste Vielzahl von Stiften von der zweiten Vielzahl von Stiften in Längsrichtung des Kühlblocks versetzt ist.

**11.** Kühlblock nach Anspruch 10, wobei die Fluidleitung einen Einlassverteilerabschnitt und einen Auslassverteilerabschnitt umfasst, wobei sich der erste Durchgang und der zweite Durchgang zwischen dem Einlass- und dem Auslassverteilerabschnitt erstrecken.

**12.** Kühlblock nach einem der Ansprüche 1-11, wobei:
die Längsachse des Durchgangs des mindestens einen Durchgangs Folgendes umfasst:

eine erste Längsachse, die sich in Längsrichtung erstreckt, und
eine zweite Längsachse, die sich in der Längsrichtung und parallel zu der ersten Längsachse erstreckt; und
die Vielzahl von Stiften Folgendes umfasst:
einen ersten Satz von Stiften mit einem ersten Stiftkopfende und einem ersten Stiftfußende, wobei die Stifte des ersten Satzes von Stiften in dem mindestens einen Durchgang derart angeordnet sind, dass die erste lineare Achse das Kopfende und das Fußende jedes Stifts des ersten Satzes von Stiften durchquert; und einen zweiten Satz von Stiften mit einem zweiten Stiftkopfende und einem zweiten Stiftfußende, wobei die Stifte des zweiten Satzes von Stiften in dem mindestens einen Durchgang derart angeordnet sind, dass die zweite lineare Achse das Kopfende und das Fußende jedes Stifts des zweiten Satzes von Stiften durchquert.

**13.** Verfahren zum Herstellen eines Kühlblocks (100), der dazu konfiguriert ist, ein wärmeerzeugendes elektronisches Bauteil (50) zu kühlen, wobei das Verfahren Folgendes umfasst:

Bereitstellen einer Basis zum Bilden eines Teils des Kühlblocks (100);
Bilden mindestens eines Durchgangs (130) einer Fluidleitung des Kühlblocks (100) durch:

Fräsen eines ersten Kanals (170) in einer Fläche der Basis entlang eines ersten Pfades, der durch einen ersten trigonometrischen Spline definiert ist, wobei der erste trigonometrische Spline durch eine verschachtelte trigonometrische Funktion definiert ist, die einen Asymmetriefaktor beinhaltet;
Fräsen eines zweiten Kanals (180) in der Fläche der Basis entlang eines zweiten Pfades, der durch einen zweiten trigonometrischen Spline definiert ist, wobei der zweite trigonometrische Spline durch die verschachtelte trigonometrische Funktion definiert ist, die den Asymmetriefaktor beinhaltet, wobei sich der erste und der zweite trigonometrische Spline in Längsrichtung des Kühlblocks (100) erstrecken und derart angeordnet sind, dass der erste Kanal (170) und der zweite Kanal (180) miteinander derart verbunden sind, dass im Betrieb das innerhalb des Durchgangs strömende Kühlfluid innerhalb des ersten Kanals (170) und des zweiten Kanals (180) strömt;
wobei das Fräsen des ersten und des zweiten Kanals den mindestens einen Durchgang (130) bildet, der eine Vielzahl von Stiften (152) aufweist, die als eine Stiftreihe in der Längsrichtung voneinander beabstandet ist.

14. Verfahren nach Anspruch 13, wobei der mindestens eine Durchgang eine lineare Achse aufweist, die sich in der Längsrichtung erstreckt, wobei der erste trigonometrische Spline und der zweite trigonometrische Spline um die lineare Achse symmetrisch sind.

15. Verfahren nach Anspruch 14, wobei:

sich der erste trigonometrische Spline von einem ersten Ende zu einem zweiten Ende erstreckt;
sich der zweite trigonometrische Spline von einem ersten Ende zu einem zweiten Ende erstreckt; und
das erste oder das zweite Ende des ersten trigonometrischen Splines und das erste oder das zweite Ende des zweiten trigonometrischen Splines deckungsgleich oder seitlich versetzt sind.

## Revendications

1. Bloc de refroidissement (100) destiné à refroidir un composant électronique générant de la chaleur (50), ce bloc de refroidissement (100) comprenant un corps doté d'un conduit de fluide (115) pour la circulation d'un fluide de refroidissement, ce conduit étant défini par au moins un passage (130) se prolongeant entre un point d'entrée (110) et un point de sortie (112), ce passage (130) comprenant :

un axe de passage longitudinal ;
première et seconde parois latérales internes (140, 142) définissant au moins un passage (130) ;
une pluralité de broches (152) disposées entre les parois latérales internes (104, 142) pour dévier le fluide de refroidissement circulant dans au moins un passage (130),
chaque broche (152) présentant une extrémité avant (160) et une extrémité arrière (158), et
la pluralité de broches (152) étant disposées en rangée dans au moins un passage (130), l'extrémité avant (160) et l'extrémité arrière (158) de chaque broche (152) étant disposées le long de l'axe longitudinal du passage, dans lequel au moins une partie de la forme du périmètre de chaque broche (152) est définie par une fonction trigonométrique imbriquée comportant un facteur d'asymétrie, la fonction trigonométrique imbriquée comportant un facteur d'asymétrie définissant une spline qui est utilisée pour fabriquer la broche (152)

2. Bloc de refroidissement selon la revendication 1, dans lequel la fonction trigonométrique imbriquée comprend une fonction sinusoïdale.

3. Bloc de refroidissement selon la revendication 1 ou la revendication 2, dans lequel la forme du périmètre de chaque broche est symétrique par rapport à l'axe de passage longitudinal et asymétrique par rapport à un axe latéral se prolongeant à travers la broche.

4. Bloc de refroidissement selon l'une quelconque des revendications 1 à 3, dans lequel la forme du périmètre de chaque broche comporte un premier côté et un second côté, le premier et le second côté étant disposés de part et d'autre de l'axe de passage longitudinal, chacun du premier côté et du second côté étant défini par une demi-longueur d'onde de la fonction trigonométrique imbriquée comportant le facteur d'asymétrie.

5. Bloc de refroidissement selon l'une quelconque des revendications 1 à 4, dans lequel l'axe du passage longitudinal est un axe linéaire central de l'au moins un passage.

6. Bloc de refroidissement selon l'une quelconque des revendications 1 à 5, dans lequel chaque broche est orientée de telle sorte que l'extrémité arrière soit en aval de l'extrémité avant.

7. Bloc de refroidissement selon l'une quelconque des revendications 1 à 6, dans lequel le passage au moins présente une pluralité de parties élargies et une pluralité de parties rétrécies réparties alternativement avec les parties élargies dans le sens longitudinal ;

   les parties élargies présentent une première largeur mesurée dans la direction latérale ;
   les parties rétrécies présentent une seconde largeur dans la direction latérale ;
   la première largeur est supérieure à la seconde largeur ; et
   les broches sont disposées dans les parties élargies.

8. Bloc de refroidissement selon l'une quelconque des revendications 1 à 7, dans lequel les première et seconde parois latérales internes sont symétriques l'une par rapport à l'autre autour de l'axe de passage longitudinal.

9. Bloc de refroidissement selon l'une quelconque des revendications 1 à 8, dans lequel les première et seconde parois latérales internes sont festonnées.

10. Bloc de refroidissement selon l'une quelconque des revendications 1 à 9, l'au moins un passage comprenant au moins une pluralité de broches comprend au moins :

    un premier passage comprenant une première pluralité de broches, et
    un second passage, adjacent au premier passage et décalé latéralement par rapport à celui-ci, comprenant une seconde pluralité de broches ;
    dans lequel la première pluralité de broches est décalée par rapport à la seconde pluralité de broches, le long d'une direction longitudinale du bloc de refroidissement.

11. Bloc de refroidissement selon la revendication 10, dans lequel le conduit de liquide comprend une partie de collecteur d'entrée et une partie de collecteur de sortie, le premier passage et le second passage se prolongeant entre les parties d'entrée et de sortie du collecteur.

12. Bloc de refroidissement selon l'une quelconque des revendications 1 à 11, dans lequel :
    l'axe longitudinal du passage d'au moins un passage comprend :

    un premier axe longitudinal se prolongeant dans une direction longitudinale, et
    un second axe longitudinal se prolongeant dans la direction longitudinale et parallèle au premier axe longitudinal ;
    et
    la pluralité de broches comprend :
    un premier ensemble de broches présentant une première tête et une première queue, les broches du premier ensemble étant disposées dans au moins un passage de telle sorte que le premier axe linéaire traverse la tête et la queue de chaque broche du premier ensemble ; et un second ensemble de broches comportant une seconde tête et une seconde queue, les broches du second ensemble étant disposées dans au moins un passage de telle sorte que le second axe linéaire traverse la tête et la queue de chaque broche du second ensemble.

13. Procédé de fabrication d'un bloc de refroidissement (100) configuré pour refroidir un composant électronique (50) générant de la chaleur, le procédé comprenant :

    la fourniture d'une base pour former une partie du bloc de refroidissement (100) ;
    la formation au moins un passage (130) d'un conduit de liquide du bloc de refroidissement (100) par :

    fraisage d'un premier canal (170) dans une surface de la base suivant un premier chemin défini par une première spline trigonométrique, la première spline trigonométrique étant définie par une fonction trigonométrique imbriquée comportant un facteur d'asymétrie ;
    fraisage d'un second canal (180) dans la surface de la base suivant un second chemin défini par une seconde spline trigonométrique, la seconde spline trigonométrique étant définie par la fonction trigonométrique imbriquée incluant le facteur d'asymétrie, les première et second splines trigonométriques se prolongeant dans une direction longitudinale du bloc de refroidissement (100) et étant disposées de telle sorte que le premier canal (170) et le second canal (180) soient interconnectés de sorte que, en utilisation, le liquide de refroidissement circulant dans le passage circule à la fois dans le premier canal (170) et dans le second canal (180) ;

ledit fraisage des premier et second canaux formant au moins un passage comportant une pluralité de broches espacées les unes des autres comme une rangée de broches dans le sens longitudinal.

14. Procédé selon la revendication 13, dans lequel l'au moins un passage présente un axe linéaire se prolongeant dans la direction longitudinale, dans lequel la première spline trigonométrique et la seconde spline trigonométrique sont symétriques par rapport à l'axe linéaire.

15. Procédé de la revendication 14, dans lequel :

la première spline trigonométrique se prolonge à partir d'une première extrémité à une seconde extrémité ;
la seconde spline trigonométrique se prolonge à partir d'une première extrémité à une seconde extrémité ; et
la première ou la seconde extrémité de la première spline trigonométrique et la première ou la seconde extrémité de la seconde spline trigonométrique sont coïncidentes ou décalées latéralement.

*FIG. 1*

**FIG. 2**

EP 4 607 585 B1

**FIG. 3**

**FIG. 4**

FIG. 5

**FIG. 6**

**FIG. 7**

**FIG. 8**

EP 4 607 585 B1

FIG. 9

27

**FIG. 10**

**FIG. 11**

**FIG. 12**

**FIG. 13**

**FIG. 14**

**FIG. 15**

**FIG. 16A**

*FIG. 16B*

**FIG. 17**

500

510

PROVIDING A BASE FOR FORMING PART OF THE COOLING BLOCK

520

FORMING AT LEAST ONE PASSAGE OF A FLUID CONDUIT OF THE
COOLING BLOCK BY:
(I) MILLING A FIRST CHANNEL IN A SURFACE OF THE BASE
FOLLOWING A FIRST PATH DEFINED BY A FIRST TRIGONOMETRIC
SPLINE COMPRISING A NESTED TRIGONOMETRIC FUNCTION
INCLUDING A FACTOR OF ASYMMETRY, AND
(II) MILLING A SECOND CHANNEL IN THE SURFACE OF THE
BASE FOLLOWING A SECOND PATH DEFINED BY A SECOND
TRIGONOMETRIC SPLINE COMPRISING A NESTED TRIGONOMETRIC
FUNCTION INCLUDING A FACTOR OF ASYMMETRY

# FIG. 18

**EP 4 607 585 B1**

**Patent documents cited in the description**

- DE 102011118483 A1